# EUROPEAN PATENT APPLICATION

(11) **EP 4 845 367 A1**
(43) Date of publication of application: **25.11.2026**
(21) Application number: 26176822.0
(22) Date of filing: 06.05.2026
(51) Int. Cl.: H10K 59/131, H10K 59/80, H10K 59/122, H10K 50/115

(54) **DISPLAY MODULE AND ELECTRONIC DEVICE INCLUDING THE SAME**

(30) Priority: 20.05.2025 KR 20250065557
(71) Applicant: Samsung Display Co., Ltd, Yongin-si, Gyeonggi-Do (KR)
(72) Inventor: LEE, Arong, Yongin-si (KR); KIM, Kyongsub, Yongin-si (KR); KWAK, Donghoon, Yongin-si (KR); LEE, Dayoung, Yongin-si (KR)
(74) Representative: Marks & Clerk LLP

(57) **Abstract**

The disclosure provides a display module that includes a circuit layer, and a display layer that includes a pixel-defining layer and a light-emitting element. The circuit layer includes an insulating layer disposed on a voltage line and having an opening defined therein, and a lower contact electrode located in the opening defined in the insulation layer and connected to the voltage line. The pixel-defining layer defines a contact opening exposing at least a portion of the lower contact electrode and a pixel opening not overlapping the contact opening. The light-emitting element is disposed in the pixel opening. The light-emitting element includes a pixel electrode, a hole transport region disposed on the pixel electrode, a light-emitting layer disposed on the hole transport region, and an electron transport region disposed on the light-emitting layer, and the electron transport region is electrically connected to the lower contact electrode via the contact opening.

## Description

### TECHNICAL FIELD

The present disclosure relates to a display module, and an electronic device including the display module. In particular, the present disclosure provides a display module with improved image quality and an electronic device that includes such a display module.

### BACKGROUND

Multi-media electronic devices, such as a television, a mobile phone, a tablet computer, a navigation unit, a game console, and a wearable device, may include display devices for displaying images. In the display module, a light-emitting element, which may be referred to as a self-luminescent type emitting element, is used in which a light-emitting material including organic compounds or quantum dots emits light in a light-emitting layer arranged between facing electrodes so as to perform a display operation.

However, depending on the region of the display module, the stability of the voltage supplied to the light-emitting element may deteriorate, which leads to uneven luminance. Accordingly, in order to provide a display module having excellent display quality and to improve the quality of an electronic device including the display module, it is required to reduce the unevenness of the voltage drop depending on the position even when the area of the display module increases.

### BRIEF SUMMARY

The present disclosure describes a display module and an electronic device including the display module. More specifically, the present disclosure relates to a display module that provides a mitigated (reduced) voltage drop depending on the position of a light-emitting element, and an electronic device that includes the display module. The display module of the present disclosure utilizes an electrical connection structure in which each of the light-emitting elements is adjacent and connected to a power line to reduce a voltage drop phenomenon, and an electronic device including the display module.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to some aspects of the present disclosure, a display module is provided that includes a circuit layer and a display layer. The circuit layer includes a voltage line, an insulating layer having an opening defined therein, and a lower contact electrode located in the opening defined in the insulating layer. The lower contact electrode is connected to the voltage line. The display layer is disposed on the circuit layer and includes a pixel-defining layer and a light-emitting element. The pixel-defining layer defines a contact opening and a pixel opening. The contact opening exposes at least a portion of the lower contact electrode, and the pixel opening does not overlap the contact opening. The light-emitting element is disposed in the pixel opening. The light-emitting element includes a pixel electrode exposed at the pixel opening, a hole transport region disposed on the pixel electrode, a light-emitting layer disposed on the hole transport region, and an electron transport region disposed on the light-emitting layer, and the electron transport region is electrically connected to the lower contact electrode via the contact opening.

In some aspects, the display layer further includes an upper contact electrode located in the contact opening. A lower surface of the upper contact electrode is in contact with the lower contact electrode, and an edge of the upper contact electrode is disposed on the pixel-defining layer.

In some aspects, the electron transport region is in contact with the edge of the upper contact electrode, the edge being on one side of the upper contact electrode.

In some aspects, an edge of the hole transport region is located on a side surface of the pixel-defining layer. In some aspects, an edge of the light-emitting layer is located on a side surface of the pixel-defining layer. In some aspects, an edge of the electron transport region is disposed on an upper surface of the pixel-defining layer.

In some aspects, the electron transport region overlaps at least a portion of the upper contact electrode.

In some aspects, an edge of the hole transport region is located on a side surface of the pixel-defining layer. In some aspects, an edge of the light-emitting layer is located on a side surface of the pixel-defining layer. In some aspects, an edge of the electron transport region is disposed on an upper surface of the upper contact electrode.

In some aspects, an upper surface of the pixel-defining layer has a higher liquid repellency than a side surface of the pixel-defining layer. In some aspects, a surface energy of the electron transport region is greater than a surface energy of the hole transport region. In some aspects, a surface energy of the electron transport region is greater than a surface energy of the light-emitting layer.

In some aspects, the electron transport region extends into the contact opening and comes into direct contact with the lower contact electrode.

In some aspects, the pixel-defining layer includes a first pixel-defining portion disposed directly on the insulating layer, and a second pixel-defining portion disposed on the first pixel-defining portion. In some aspects, the second pixel-defining portion has an upper surface having liquid repellency. In some aspects, the entirety of the pixel-defining layer located between the pixel opening and the contact opening and completely overlapping the electron transport region is withing the first pixel-defining portion.

In some aspects, the light-emitting layer includes a quantum dot.

In some aspects, the light-emitting element does not comprise an additional electrode facing the pixel electrode with the light-emitting layer therebetween.

In some aspects of the present disclosure, a display module includes a display region and a non-display region located on at least one side of the display region. The display region includes a plurality of pixel regions spaced apart from each other in a plan view and a peripheral region defining each pixel region of the plurality of pixel regions. In some aspects, the display module includes a circuit layer, a pixel-defining layer and a light-emitting element. The circuit layer includes a first voltage line, a second voltage line, an insulating layer, and a lower contact electrode. The first voltage line and the second voltage line correspond to the peripheral region and are arranged separately from each other. The insulating layer defines a first opening exposing the first voltage line, and a second opening exposing the second voltage line. The lower contact electrode is located in the first opening and is in contact with the first voltage line. The pixel-defining layer is disposed on the circuit layer. The pixel-defining layer defines a pixel opening and a contact opening. The pixel opening corresponds to each pixel region of the plurality of pixel regions, and the contact opening overlaps the first opening and exposes the first voltage line of the peripheral region. The light-emitting element includes a pixel electrode exposed at the pixel opening and disposed on the insulating layer, a hole transport region disposed on the pixel electrode inside the pixel opening, a light-emitting layer disposed on the hole transport region inside the pixel opening, and an electron transport region disposed on the light-emitting layer. The only electrode of the light-emitting element is the pixel electrode. The electron transport region is electrically connected to the first voltage line via the contact opening, and the pixel electrode extends into the second opening and is electrically connected to the second voltage line.

In some aspects, the display module further includes an upper contact electrode located in the contact opening. In some aspects, the upper contact electrode electrically connects the lower contact electrode to the electron transport region.

In some aspects, the upper contact electrode covers the lower contact electrode that is electrically connected to the electron transport region and extends onto an upper surface of the pixel-defining layer. In some aspects, the electron transport region is at least in contact with one side of the upper contact electrode or overlaps the upper contact electrode.

In some aspects, the electron transport region extends from the pixel opening toward the contact opening, and the electron transport region and the lower contact electrode are in contact with each other inside the contact opening.

In some aspects, the light-emitting layer includes a quantum dot. In some aspects, the electron transport region includes at least one of ZnO, ZnMgO, or MgO.

In some aspects, the electron transport regions of the plurality of pixel regions are not connected to each other. In some aspects, each light-emitting element located in a respective pixel region of the plurality of pixel regions emits light in such a manner that the electron transport region receives a first voltage provided by the first voltage line electrically connected at the contact opening adjacent to the pixel opening, and the pixel electrode receives a second voltage provided by the second voltage line connected at the second opening.

In some aspects, the plurality of pixel regions includes a first pixel region, a second pixel region, and a third pixel region, and the first, second, and third pixel regions are arranged in a first direction. In some aspects, the first voltage line extends in the first direction entirely across the display region. In some aspects, in a plan view, the electron transport region of the light-emitting element located in each of the first to third pixel regions, respectively, includes a respective contact region that extends toward the first voltage line adjacent to the electron transport region in a second direction transverse to the first direction.

In some aspects of the present disclosure, an electronic device is provided that includes a display module configured to provide an image, and a power module configured to supply power to the display module. The display module includes a circuit layer and a display layer. The circuit layer includes a voltage line, an insulating layer disposed on the voltage line and a lower contact electrode. The insulating layer has an opening defined therein. The lower contact electrode is located in the opening in the insulating layer. The lower contact electrode is connected to the voltage line. The display layer is disposed on the circuit layer and includes a pixel-defining layer and a light-emitting element. The pixel-defining layer defines a contact opening and a pixel opening. The contact opening exposes at least a portion of the lower contact electrode. The pixel opening does not overlap the contact opening. The light-emitting element is disposed in the pixel opening. The light-emitting element includes a pixel electrode exposed at the pixel opening, a hole transport region disposed on the pixel electrode, a light-emitting layer disposed on the hole transport region, and an electron transport region disposed on the light-emitting layer, and the electron transport region is electrically connected to the lower contact electrode via the contact opening.

In some aspects, the electronic device further includes at least one of one or more processors or one or more memories. In some aspects, the electronic device represents an image display device, a wearable device, or an in-vehicle device.

At least some of the above and other features of the invention are set out in the claims.

### BRIEF DESCRIPTION OF THE FIGURES

The above and other aspects and features of the present disclosure will become more apparent by describing in detail example embodiments thereof with reference to the attached drawings, in which:
FIG. 1 is a block diagram of an electronic device according to an embodiment of the present disclosure;
FIG. 2 shows schematic diagrams of electronic devices according to an embodiment of the present disclosure;
FIG. 3 is a perspective view of an electronic device according to an embodiment of the present disclosure;
FIG. 4 is a plan view of a display module to an embodiment of the present disclosure;
FIG. 5 is a cross-sectional view of a display module according to an embodiment of the present disclosure;
FIG. 6 is a cross-sectional view of a portion of a display module according to an embodiment of the present disclosure;
FIG. 7 is a plan view of a display panel according to an embodiment of the present disclosure;
FIG. 8 is an equivalent circuit diagram of a pixel according to an embodiment of the present disclosure;
FIG. 9 is a cross-sectional view of a portion of a display panel according to an embodiment of the present disclosure;
FIG. 10 is a plan view of a display panel according to an embodiment of the present disclosure;
FIG. 11 is a plan view of a portion of a display panel according to an embodiment of the present disclosure;
FIG. 12 is a plan view of a portion of a display panel according to an embodiment of the present disclosure;
FIG. 13 is a cross-sectional view of a portion of a display panel according to an embodiment of the present disclosure;
FIG. 14A is a cross-sectional view of a portion of a display panel according to an embodiment of the present disclosure;
FIG. 14B is a plan view of a portion of a display panel according to an embodiment of the present disclosure;
FIG. 15A is a cross-sectional view of a portion of a display panel according to an embodiment of the present disclosure;
FIG. 15B is a plan view of a portion of a display panel according to an embodiment of the present disclosure;
FIGS. 16A to 16F are diagrams illustrating example steps in a method for manufacturing a display module, according to an embodiment of the present disclosure;
FIG. 17 is a plan view of a portion of a display panel according to an embodiment of the present disclosure;
FIG. 18 is a cross-sectional view of a portion of a display panel according to an embodiment of the present disclosure;
FIG. 19A is a cross-sectional view of a portion of a display panel according to an embodiment of the present disclosure;
FIG. 19B is a plan view of a portion of a display panel according to an embodiment of the present disclosure; and
FIGS. 20A to 20F are diagrams illustrating example steps in a method for manufacturing a display module, according to an embodiment of the present disclosure.

### DETAILED DESCRIPTION

While specific embodiments are shown in the drawings and described in detail herein below, the present disclosure may be modified in a variety of ways and realized in many different forms. Accordingly, it will be appreciated that the present disclosure is not limited to the specific disclosed forms, and should be construed to include all modifications, equivalents, or replacements included within the scope of the present disclosure.

It is to be understood that when an element (or a region, a layer, a portion, or the like) is referred to as being "on", "connected to" or "coupled to" another element, the element may be directly disposed on, connected to, or coupled to the other element, or other elements may be disposed therebetween.

It is to be understood that like reference numerals or symbols refer to like elements throughout the present disclosure. It is further to be understood that, in the drawings, the thicknesses, ratios, and sizes of the elements may be exaggerated or reduced for convenience of explanation. For example, a size and thickness of each component shown in the drawing are arbitrarily shown for convenience of explanation, and thus the present implementation of the teachings of the present disclosure are not necessarily limited to what is shown.

It is to be understood that, "A and/or B" refers to either A, B, or both A and B; and "at least one of A and B" indicates the case where it is A, or B, or both A and B. Thus, the term "and/or" includes any and all combinations of one or more of the associated listed elements.

It is to be understood that, although the terms such as "first", "second", etc. may be used herein to describe various elements, the elements are not to be limited by these terms. These terms are only used to distinguish one element, component, region, layer or section from another element, component, region, layer or section. For instance, a first element, component, region, layer or section discussed below could be termed a second element, component, region, layer or section. Similarly, a second element, component, region, layer or section could be termed a first element, component, region, layer or section.

It is further to be understood that singular expressions such as "a", "an" and "the" are intended to include the plural forms as well, unless the context clearly indicates otherwise.

It is also to be understood that spatially relative terms, such as "below", "under", "on the lower side", "above", "over", "on the upper side", or the like, may be used herein for ease of description to describe the relationships between the elements as illustrated in the drawings. Thus, the terms are relative concepts and are described on the basis of the directions indicated in the drawings.

It is further to be understood that the terms "comprises, includes, has" and/or "comprising, including, having", mean that a feature, number, step, operation, element, component or combination thereof, described therein is present, and the terms do not preclude the possibility of a presence or addition of one or more other features, numbers, steps, operations, elements, components, and/or combinations thereof.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Features of various example embodiments of the present disclosure may be combined partially or totally. As will be clearly appreciated by those skilled in the art, technically various interactions and operations are possible. Various example embodiments can be practiced individually or in combination.

It is to be understood that, where the implementation is otherwise feasible, specific process sequences may be performed in a different order than described. For example, two processes described sequentially may be performed substantially simultaneously, or may proceed in the reverse order from that described.

In addition, the terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

Furthermore, the term "spaced apart" means that there is a distance between two objects. For example, if A is spaced apart from B, there is a physical distance between A and B such that A and B do not touch each other.

Additionally, the terms "about," "generally," and "substantially", and the like, are intended to mean that a person of ordinary skill would understand the terms to mean that slight deviations from absolute are included within the scope of the term so modified. For example, when a second direction is substantially transverse to a first direction, a person of ordinary skill would understand that the angle between the two directions may have a slight deviation from ninety degrees.

Hereinafter, example embodiments of the present disclosure will be described in detail with reference to the accompanying drawings. When describing with reference to the drawings, identical or corresponding components are given the same drawing reference numerals and redundant descriptions thereof are omitted.

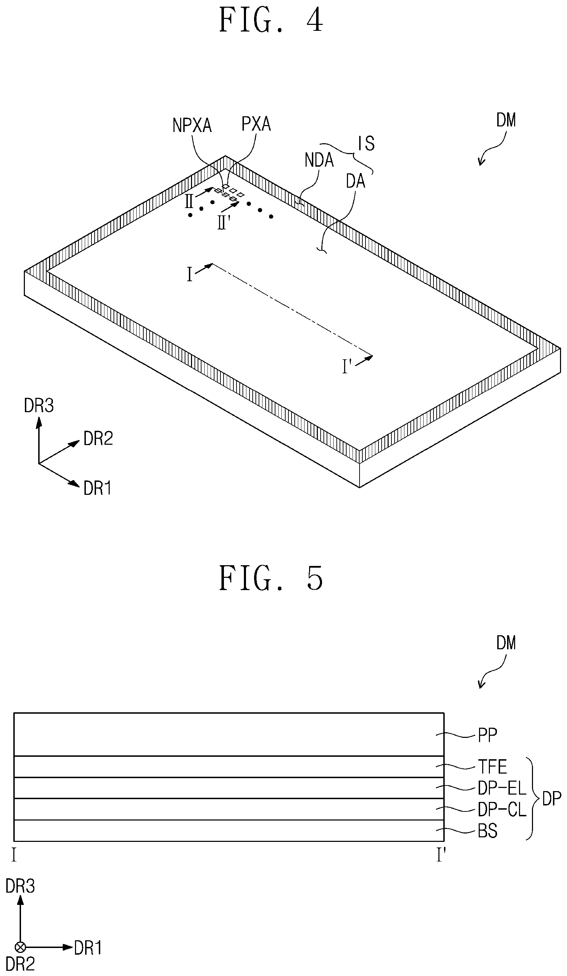

As used herein, "plan view" may be defined as viewed in a direction that is normal to a plane illustrated in a diagram ("normal direction"). For example, in FIG. 4, a plane can be defined to show a display area of a display module, or an electronic device including a display module, such as a smartphone, a smartwatch, and the like, with a display module. The plane can be defined by the first direction DR1 and the second direction DR2, where DR2 is transverse to DR1. Then the "plan view" refers to a third direction DR3 which is normal to the plane. The term "cross-sectional view" can be defined by DR1 and DR3, or by DR2 and DR3. Although a rectangular shape is shown in FIG. 4, it is to be understood that the display area or display module can be of any shape.

A display module, according to some aspects, may be included in other electronic devices. In some aspects, the display module may further include a module or device having additional functions in addition to the display function.

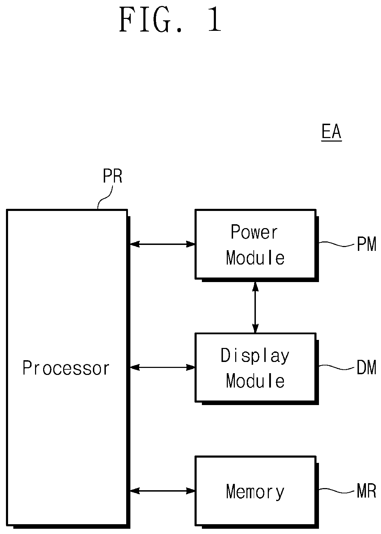

FIG. 1 is a block diagram of an electronic device according to an embodiment of the present disclosure. Referring to FIG. 1, an electronic device EA according to an embodiment may include a display module DM, a processor PR, a memory MR, and a power module PM.

The processor PR may include at least one of a central processing unit (CPU), an application processor (AP), a graphic processing unit (GPU), a communication processor (CP), an image signal processor (ISP), or a controller.

The memory MR may store data information that is required for an operation of the processor PR or the display module DM. When the processor PR executes an application stored in the memory MR, image data signals and/or input control signals may be transmitted to the display module DM, and the display module DM may process the received signals and output image information via a display screen. The display module DM may include a display panel for displaying images.

The power module PM may include a power supply module, such as a power adapter and a battery device, and a power conversion module that converts the power supplied by the power supply module and generates power required for the operations of the electronic device EA.

The electronic device EA may include a display device for generating and displaying an image. The display device may be a part that includes the display module DM. Also, some of the components or individual modules of the electronic device EA may be in a display device and the others may be provided separately from the display device. For example, the display device may include the display module DM, and the processor PR, the memory MR, and the power module PM may be provided in the form of other devices inside the electronic device EA which are different from the display device.

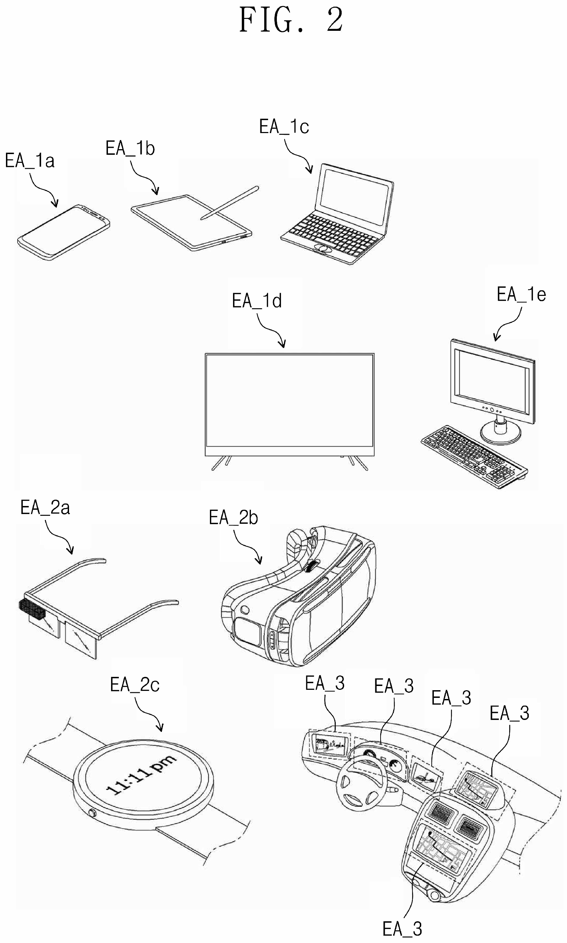

FIG. 2 shows schematic diagrams of electronic devices according to various embodiments of the present disclosure.

Referring to FIG. 2, various electronic devices including display devices according to embodiments may include not only image display electronic devices, such as a smartphone EA_1a, a tablet personal computer (PC) EA_1b, a laptop EA_1c, a television (TV) EA_1d, and a desktop monitor EA_1e, but also wearable electronic devices, such as smart glasses EA_2a, a head-mounted display EA_2b, and a smart watch EA_2c, and vehicle electronic devices EA_3, such as a room mirror display and a center information display (CID) placed on an instrument panel, a center fascia, or a dashboard of a vehicle.

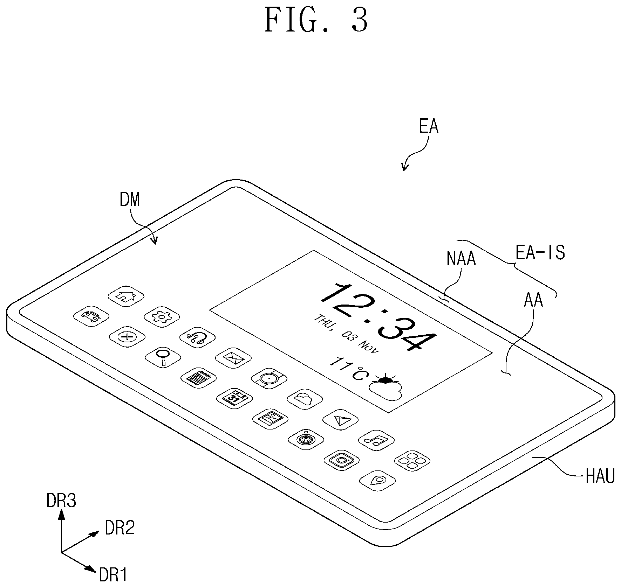

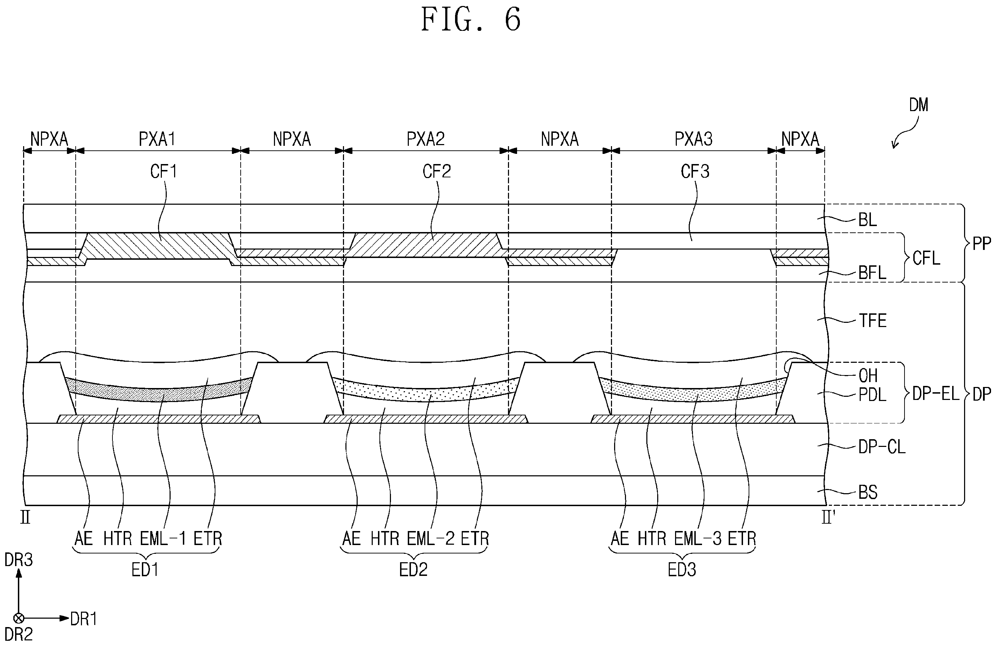

FIG. 3 is a perspective view showing an electronic device according to an embodiment of the present disclosure. FIG. 4 is a perspective view of a display module according to an embodiment of the present disclosure. FIG. 5 is a cross-sectional view of a display module according to an embodiment of the present disclosure, and FIG. 6 is a cross-sectional view showing a portion of a display module according to an embodiment of the present disclosure. FIG. 5 may be a cross-sectional view corresponding to line I-I' of FIG. 4, and FIG. 6 may be a cross-sectional view corresponding to line II-II' of FIG. 4.

The electronic device EA according to an embodiment may include a display module DM that displays an image via a display surface EA-IS. The display module DM may be accommodated in a housing HAU. The electronic device EA may include the display module DM, a controller for controlling an operation of the display module DM, and the like.

The display surface EA-IS of the electronic device EA may have a rectangular shape in a plan view, which has long sides extending in a first direction DR1 and short sides extending in a second direction DR2 crossing the first direction DR1. However, the disclosed subject matter is not limited thereto, and the display surface EA-IS may have various shapes, such as a circle or a polygon.

As used herein, a third direction DR3 may be defined as a direction that is substantially perpendicular to the plane defined by the first direction DR1 and the second direction DR2. The front surface (or upper surface) and the rear surface (or lower surface) of each of members constituting the electronic device EA may be opposed to each other in the third direction DR3, and a normal direction of each of the front and rear surfaces may be substantially parallel to the third direction DR3. The distance between the front surface and the rear surface, which is defined in the third direction DR3, may correspond to the thickness of a member.

As used herein, the expression "in a plan view" may be defined as a state when viewed in the third direction DR3. In other words, "in a plan view" may be described based on the plane defined by the first direction DR1 and the second direction DR2 together. As used herein, the expression "in a cross-sectional view" may be defined as a state when viewed in the first direction DR1 or the second direction DR2. The directions indicated by the first to third directions DR1, DR2, and DR3 are relative concepts and may be changed to other directions.

FIG. 3 illustrates a tablet terminal as an example of the electronic device EA. Electronic modules, a camera module, a power module, etc., mounted on a main board, may be arranged in a bracket/housing HAU, etc., together with the display module DM to form the tablet terminal. The embodiment is not limited thereto. The display module DM and a display panel according to an embodiment described below may be utilized not only in large scale electronic devices, such as a television, a monitor, or an outdoor advertising board, but also in small-to-medium scale electronic devices, such as a personal computer, a notebook computer, a personal digital terminal, an automobile navigation unit, a game console, a smartphone, a tablet, a smart watch, and a camera. Also, those described above are provided only as examples, and the display module DM according to an embodiment may be employed by other electronic devices without departing from the scope of the present disclosure. The electronic device EA including the display module DM may also be referred to as a display device.

An embodiment shows the electronic device EA including the display module DM having a planar display surface, but the disclosed subject matter is not limited thereto. The electronic device EA may include a curved display surface or a 3-dimensional display surface. For example, the 3-dimensional display surface may include a plurality of display regions oriented in different directions, and may include a bending display surface.

Referring to FIG. 3, the display surface EA-IS includes an active region AA on which an image is displayed and a bezel region NAA adjacent to the active region AA. The bezel region NAA does not display an image. FIG. 3 shows icon images as an example of an image. The active region AA may be referred to as a display region DA of the display module DM, and the bezel region NAA may be referred to as a non-display region NDA of the display module DM.

As shown in FIG. 3, the active region AA may have a substantially quadrangular shape. The "substantially quadrangular shape" includes not only a quadrangular shape in the mathematical sense, but also a quadrangular shape in which a curved boundary rather than a vertex is defined in a vertex region (or corner region).

The bezel region NAA may surround the active region AA. However, the disclosed subject matter is not limited thereto, and the shape of the bezel region NAA may vary. For example, the bezel region NAA may be located only on one side of the active region AA.

FIG. 4 is a perspective view of a display module according to an embodiment of the present disclosure. FIG. 5 is a cross-sectional view of a display module according to an embodiment of the present disclosure. FIG. 6 is a more detailed cross-sectional view of a display module according to an embodiment of the present disclosure. FIG. 5 may be a cross-sectional view corresponding to line I-I' of FIG. 4, and FIG. 6 may be a cross-sectional view corresponding to line II-II' of FIG. 4.

Referring to FIG. 4, the display module DM includes a display surface IS, and the display module DM may display an image on the display surface IS. The display surface IS of the display module DM may correspond to the display surface EA-IS of the electronic device EA.

The display surface IS may include a display region DA and a non-display region NDA. A plurality of pixel regions PXA may be arranged in the display region DA. A peripheral region NPXA is located around the pixel regions PXA. The pixel regions PXA may be referred to as light-emitting regions, and the peripheral region NPXA may be referred to as a non-light emitting region.

Pixel regions are not placed in the non-display region NDA of the display surface IS, and the non-display region NDA may surround the display region DA. However, the embodiments of the disclosed subject matter are not limited thereto, and the non-display region NDA may be located only on one side of the display region DA. In an embodiment, a light-emitting element may be located in the display region DA, and a power supply line or the like for supplying electrical signals to the light-emitting element may be located in the non-display region NDA.

Referring to FIGS. 5 and 6, the display module DM according to an embodiment may include a display panel DP. The display panel DP may be configured to substantially generate image data. The display panel DP according to an embodiment may be provided in the electronic device EA (FIG. 3) according to an embodiment and configured to display an image. The display panel DP according to an embodiment may be a light-emitting display panel. In an embodiment, the display panel DP may include inorganic light-emitting materials, such as quantum dots.

The display panel DP may include a base layer BS, a circuit layer DP-CL, a display layer DP-EL, and an encapsulation layer TFE, sequentially stacked in the direction along a third directional axis DR3.

The display layer DP-EL may include light-emitting elements ED1, ED2, and ED3. The plurality of pixel regions PXA may be regions that emit light generated by respective light-emitting elements ED1, ED2, and ED3.

The encapsulation layer TFE may be directly disposed on the display layer DP-EL. The encapsulation layer TFE may cover the light-emitting elements ED1, ED2, and ED3 of the display layer DP-EL.

The display module DM according to an embodiment may further include an optical member PP. The optical member PP may be disposed on the display panel DP. The optical member PP may be disposed on the display panel DP and control the reflection of light from the display panel DP caused by external light.

The display module DM according to an embodiment may include the plurality of pixel regions PXA that repeat across the display region DA. The pixel regions PXA in the display module DM according to an embodiment may be arranged in a stripe form in a plan view. Referring to FIG. 4, the plurality of pixel regions PXA may be aligned along a first directional axis DR1 or a second directional axis DR2. However, the disclosed subject matter is not limited thereto, and the pixel regions PXA may be arranged in the form of PENTILE^{™} or Diamond Pixel^{™}.

Also, in FIG. 4 and the like, it is illustrated that the areas of the pixel regions PXA in a plan view are all similar to each other, but the disclosed subject matter is not limited thereto. The areas of the pixel regions PXA in a plan view may vary depending on the wavelength region of light emitted therefrom.

Referring to FIGS. 4 and 6, the pixel regions PXA may include first to third pixel regions PXA1, PXA2, and PXA3. In the display module DM according to an embodiment, the first to third pixel regions PXA1, PXA2, and PXA3 may be distinct from each other in a plan view and emit light in different wavelength regions.

Also, the display module DM according to an embodiment may include the peripheral region NPXA located around the first to third pixel regions PXA1, PXA2, and PXA3. The peripheral region NPXA sets the boundaries between the first to third pixel regions PXA1, PXA2, and PXA3. The peripheral region NPXA may surround each of the first to third pixel regions PXA1, PXA2, and PXA3. A structure, for example, a pixel-defining layer PDL, may overlap the peripheral region NPXA to prevent color mixing between the first to third pixel regions PXA1, PXA2, and PXA3. Also, in the peripheral region NPXA of the display module DM according to an embodiment, there may be provided a voltage line providing an electrical signal to each of the pixel regions and a connection electrode electrically connecting the voltage line to the light-emitting element of the pixel region.

Each of the first to third pixel regions PXA1, PXA2, and PXA3 may be a region separated by the pixel-defining layer PDL. The peripheral region NPXA may represent regions between adjacent first to third pixel regions PXA1, PXA2, and PXA3 and may correspond to the pixel-defining layer PDL.

The first to third pixel regions PXA1, PXA2, and PXA3 may represent regions that emit light generated by the first to third light-emitting elements ED1, ED2, and ED3, respectively. The first to third pixel regions PXA1, PXA2, and PXA3 may be spaced apart from each other in a plan view.

The pixel-defining layer PDL may distinguish the first to third light-emitting elements ED1, ED2, and ED3 from each other. Light-emitting layers EML-1, EML-2, and EML-3 of the first to third light-emitting elements ED1, ED2, and ED3 may be arranged in pixel openings OH defined in the pixel-defining layer PDL and distinguished from each other.

The pixel-defining layer PDL may be made of polymeric resin. For example, the pixel-defining layer PDL may include polyacrylate-based resin or polyimide-based resin. Also, the pixel-defining layer PDL may include an inorganic material in addition to the polymeric resin. The pixel-defining layer PDL may be made of a light-absorbing material or include black pigment or black dye. The pixel-defining layer PDL including the black pigment or black dye may form a black pixel-defining layer. When forming the pixel-defining layer PDL, carbon black or the like may be used as the black pigment or black dye, but the disclosed subject matter is not limited thereto, and other materials known by those skilled in the art may be used. Also, the pixel-defining layer PDL may be made of an inorganic material. For example, the pixel-defining layer PDL may be made of inorganic materials, such as silicon nitride (SiNx), silicon oxide (SiOx), and silicon oxynitride (SiOxNy).

The first to third pixel regions PXA1, PXA2, and PXA3 may be defined based on the colors of light generated by the first to third light-emitting elements ED1, ED2, and ED3, respectively. For example, in the display module DM according to an embodiment, the first pixel region PXA1 may correspond to a red light-emitting region, the second pixel region PXA2 may correspond to a green light-emitting region, and the third pixel region PXA3 may correspond to a blue light-emitting region.

In the display module DM according to an embodiment, the light-emitting elements ED1, ED2, and ED3 may emit light in different wavelength regions. For example, in an embodiment, the first light-emitting element ED1 may correspond to a red light-emitting element for emitting red light, the second light-emitting element ED2 may correspond to a green light-emitting element for emitting green light, and the third light-emitting element ED3 may correspond to a blue light-emitting element for emitting blue light.

In FIG. 6, etc., three distinct pixel regions PXA1, PXA2, and PXA3 are shown, but the disclosed subject matter is not limited thereto. Rather, the display module DM according to an embodiment may include four or more light-emitting regions having different light-emitting characteristics.

In the display panel DP, the base layer BS may represent a member that provides a base surface on which the display layer DP-EL and the circuit layer DP-CL are disposed. The base layer BS may include a glass substrate, a metal substrate, or a plastic substrate. However, the embodiment is not limited thereto, and the base layer BS may include an inorganic layer, an organic layer, or a composite material layer.

In an embodiment, the circuit layer DP-CL may be disposed on the base layer BS, and the circuit layer DP-CL may include a plurality of transistors (not shown). Each of the transistors (not shown) may include a control electrode, an input electrode, and an output electrode. For example, the circuit layer DP-CL may include a switching transistor, a drive transistor, a power supply line, or the like for driving the light-emitting elements ED1, ED2, and ED3 of the display layer DP-EL.

The encapsulation layer TFE may cover the light-emitting elements ED1, ED2, and ED3. The encapsulation layer TFE may seal the display layer DP-EL. The encapsulation layer TFE may represent a thin-film encapsulation layer. The encapsulation layer TFE may include a plurality of stacked layers. The encapsulation layer TFE according to an embodiment may include at least one inorganic film (hereinafter referred to as an encapsulating inorganic film) and at least one organic film (hereinafter referred to as an encapsulating organic film).

The display module DM according to an embodiment may further include the optical member PP. The optical member PP may represent a reflection-reducing layer that lowers reflectance due to external light. For example, the optical member PP may include a polarization film that includes a phase retarder and/or a polarizer, a plurality of reflective layers that induce destructive interference of reflected light, or color filters that are arranged corresponding to pixel arrangements and light-emitting colors of the display panel DP. Also, in an embodiment, the optical member PP may be omitted.

Referring to FIG. 6, in an embodiment, the optical member PP may include a base substrate BL and a color filter layer CFL.

The base substrate BL may represent a member that provides a base surface on which the color filter layer CFL is disposed. The base substrate BL may include a glass substrate, a metal substrate, or a plastic substrate. However, the embodiment is not limited thereto, and the base substrate BL may include an inorganic layer, an organic layer, or a composite material layer.

In an embodiment, the color filter layer CFL may include first to third color filters CF1, CF2, and CF3. The first to third color filters CF1, CF2, and CF3 may correspond to the first to third light-emitting elements ED1, ED2, and ED3, respectively. For example, the first color filter CF1 may represent a red filter, the second color filter CF2 may represent a green filter, and the third color filter CF3 may represent a blue filter. Also, the third color filter CF3 may represent a transparent filter made of transparent photosensitive resin. The first to third color filters CF1, CF2, and CF3 may correspond to the first to third pixel regions PXA1, PXA2, and PXA3, respectively.

Also, the plurality of color filters CF1, CF2, and CF3, through which different light is transmitted, may overlap each other in regions corresponding to the peripheral region NPXA located between the pixel regions PXA1, PXA2, and PXA3. The plurality of color filters CF1, CF2, and CF3 may overlap each other in the third direction DR3, which is the thickness direction, and thus, the boundaries between the adjacent pixel regions PXA1, PXA2, and PXA3 may be defined. This increases the effect of blocking external light and provides the function of a black matrix. The overlapping structure of the plurality of color filters CF1, CF2, and CF3 may have a function of preventing color mixing.

The color filter layer CFL may further include a buffer layer BFL. For example, the buffer layer BFL may represent a protective layer for protecting the first to third color filters CF1, CF2, and CF3. The buffer layer BFL may represent an inorganic layer including at least one of silicon nitride, silicon oxide, or silicon oxynitride. The buffer layer BFL may be formed as a single layer or a plurality of layers.

In the display panel DP according to an embodiment, the first to third light-emitting elements ED1, ED2, and ED3 may include pixel electrodes AE, hole transport regions HTR, light-emitting layer EML-1, EML-2, and EML-3, and electron transport regions ETR. In an embodiment, the first to third light-emitting elements ED1, ED2, and ED3 may not include any additional electrodes that face the pixel electrodes AE with the light-emitting layers EML-1, EML-2, and EML-3 therebetween. In an embodiment, the pixel electrode AE may be referred to as a first electrode, and each of the first to third light-emitting elements ED1, ED2, and ED3 may include the first electrode and not include a second electrode facing the first electrode. That is, each of the light-emitting elements ED1, ED2, and ED3 includes only the pixel electrode AE.

In an embodiment, in each of the first to third light-emitting elements ED1, ED2, and ED3, the pixel electrode AE and the electron transport region ETR may each be connected to a voltage line that provides an electrical signal. In an embodiment, the pixel electrode AE may be electrically connected to a drive voltage line (a second voltage line), and the electron transport region ETR may be electrically connected to a common voltage line (a first voltage line). In an embodiment, the electrical connection structure between the light-emitting elements ED1, ED2, and ED3 and the common voltage line is described below in more detail.

The pixel electrode AE may be exposed at the pixel opening OH of the pixel-defining layer PDL. The pixel electrode AE is conductive. The pixel electrode AE may be made of a metal material, a metal alloy, or a conductive compound. The pixel electrode AE may represent an anode or a cathode. The pixel electrode AE may include a transmissive electrode, a transflective electrode, or a reflective electrode. The pixel electrodes AE may be arranged separately so as to correspond to respective pixel regions PXA1, PXA2, and PXA3.

The hole transport regions HTR may be arranged between the pixel electrodes AE and the light-emitting layers EML-1, EML-2, and EML-3, and the electron transport regions ETR may be arranged on the light-emitting layers EML-1, EML-2, and EML-3. The hole transport region HTR may be located inside the pixel opening OH of the pixel-defining layer PDL. Also, the light-emitting layers EML-1, EML-2, and EML-3 may be arranged on the hole transport regions HTR inside the pixel openings OH. The electron transport region ETR may be located inside the pixel opening OH, and at least a portion of the electron transport region ETR may extend onto the pixel-defining layer PDL.

In an embodiment, the hole transport regions HTR, the light-emitting layers EML-1, EML-2, and EML-3, and the electron transport regions ETR may be arranged separately so as to correspond to the respective pixel regions PXA1, PXA2, and PXA3. The hole transport regions HTR, the light-emitting layers EML-1, EML-2, and EML-3, and the electron transport regions ETR are each not provided as a common layer across all of the pixel regions PXA1, PXA2, and PXA3, but are distinct from each other in the pixel regions PXA1, PXA2, and PXA3 and not connected to components of the light-emitting elements in adjacent pixel regions.

In an embodiment, the light-emitting layers EML-1, EML-2, and EML-3 may include quantum dots.

The quantum dots represent crystals of semiconductor compounds. The quantum dots emit light having various emission wavelengths depending on the size of the crystals. The quantum dots may also emit light having various emission wavelengths by adjusting a ratio of elements in the semiconductor compound.

The diameter of a quantum dot may be, for example, about 1 nm to about 10 nm. The quantum dots may be synthesized by a wet chemical process, a metal organic chemical vapor deposition process, a molecular beam epitaxy process, or a process similar thereto.

The quantum dots may be selected from among a group II-VI compound, a group III-V compound, a group III-VI compound, a group I-III-VI compound, a group II-IV-V compound, a group IV-VI compound, a group IV element, a group IV compound, and a combination thereof.

The group II-VI compound may be selected from the group consisting of: a binary compound selected from the group consisting of CdSe, CdTe, CdS, ZnS, ZnSe, ZnTe, ZnO, HgS, HgSe, HgTe, MgSe, MgS, and a mixture thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, and a mixture thereof. The group II-VI semiconductor compound may further include a group I metal and/or a group IV element. The group I-II-VI compound may be selected from CuCdS or CuZnS, and the group II-IV-VI compound may be selected from ZnSnS, etc. The group I-II-IV-VI compound may be selected from quaternary compounds that are selected from the group consisting of Cu₂ZnSnS₂, Cu₂ZnSnS₄, Cu₂ZnSnSe₄, Ag₂ZnSnS₂, and a mixture thereof.

The group III-VI compound may include binary compounds, such as In₂S₃ and In₂Se₃, ternary compounds, such as InGaS₃ and InGaSe₃, or any combination thereof.

The group I-III-VI compound may be selected from among ternary compounds selected from the group consisting of AgInS, AgInS₂, CuInS, CuInS₂, AgGaS₂, CuGaS₂, CuGaO₂, AgGaO₂, AgAlO₂, and a mixture thereof and quaternary compounds such as AgInGaS₂ and CuInGaS₂.

The group III-V compound may be selected from the group consisting of: a binary compound selected from the group consisting of GaN, GaP, GaAs, GaSb, AlN, AlP, AlAs, AlSb, InN, InP, InAs, InSb, and a mixture thereof; a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof; and a quaternary compound selected from the group consisting of GaAlNP, GaAlNAs, GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof. The group III-V compound may further include group II metal. For example, InZnP or the like may be selected as the group III-II-V compound.

The group IV-VI compound may be selected from the group consisting of: a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; and a quaternary compound selected from the group consisting of SnPbSSe, SnPbSeTe, SnPbSTe, and a mixture thereof.

Examples of the group II-IV-V semiconductor compound may include a ternary compound selected from the group consisting of ZnSnP, ZnSnP₂, ZnSnAs₂, ZnGeP₂, ZnGeAs₂, CdSnP₂, CdGeP₂ and a mixture thereof.

The group IV element may be selected from the group consisting of Si, Ge, and a mixture thereof. The group IV compound may be a binary compound selected from the group consisting of SiC, SiGe, and a mixture thereof.

Each element contained in multi-element compounds, such as the binary compound, the ternary compound, and the quaternary compound, may exist in a particle at a uniform concentration or at non-uniform concentrations. That is, the chemical formula indicating the quantum dot represents the type of elements contained in the quantum dot compound, and the ratio of elements in the compound may vary.

Also, the binary compound, the ternary compound, or the quaternary compound may exist in a particle at a uniform concentration or may exist in the same particle but be distributed at partially different concentrations. Also, a core/shell structure in which one quantum dot surrounds another quantum dot is also possible. The core/shell structure may have a concentration gradient in which the concentration of elements present in the shell decreases toward the core.

The shell of the quantum dot may act as a protective layer for preventing chemical degradation of the core and maintaining the semiconductor characteristics and/or as a charging layer for imparting electrophoretic characteristics to the quantum dot. The shell may have a single layer or multiple layers. Examples of the shell of the quantum dot may include metal or non-metal oxide, a semiconductor compound, or a combination thereof.

For example, the examples of the metal or non-metal oxide may include binary compounds, such as SiO₂, Al₂O₃, TiO₂, ZnO, MnO, Mn₂O₃, Mn₃O₄, CuO, FeO, Fe₂O₃, Fe₃O₄, CoO, Co₃O₄, and NiO, or ternary compounds, such as MgAl₂O₄, CoFe₂O₄, NiFe₂O₄, and CoMn₂O₄, but the embodiments of the present disclosure are not limited thereto, and other compounds may be used.

Also, the examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, and AlSb, but the embodiments of the present disclosure are not limited thereto.

For example, when the quantum dot of the group III-V compound has a core-shell structure, the quantum dot may contain InP or InZnP as the core and ZnSeS as the shell, or the quantum dot may have a double-shell structure of ZnSe/ZnS. However, the embodiment of the disclosed subject matter is not limited thereto, and the quantum dots may have any combination of cores and shells selected from among the semiconductor compounds described above.

The quantum dot may have a full width of half maximum (FWHM) of an emission wavelength spectrum of about 45 nm or less, preferably about 40 nm or less, and more preferably about 30 nm or less, and in this range, color purity and color reproducibility may be improved. In addition, the light emitted from these quantum dots is emitted in all directions, which may improve the optical viewing angle.

Also, the shape of quantum dot is not specifically limited to those commonly used in the art. However, more specifically, nanoparticles having a spherical, pyramidal, multi-arm, or cubic shape may be used. Also, nanotubes, nanowires, nanofibers, nanoplate particles, or the like may be used.

In the quantum dots, the energy band gap may be controlled by adjusting the size of the quantum dots or the ratio of elements in the quantum dot compound. Accordingly, light having various wavelengths may be obtained from the light-emitting layers EML-1, EML-2, and EML-3 that contain the quantum dots. Therefore, the light-emitting element that emits light having multiple wavelengths may be obtained by using quantum dots as described above (using quantum dots of different sizes or quantum dots with different ratios of elements in the quantum dot compound). Specifically, the adjustment of the size of the quantum dots or the ratio of elements in the quantum dot compound may be selected such that red, green, and/or blue light is emitted. Also, the quantum dots may be configured to emit white light, which is a combination of different colors of light.

In an embodiment, as the particle size of a quantum dot decreases, the quantum dot emits light in a short wavelength region. For example, in quantum dots having the same core, the particle size of quantum dots that emit green light may be smaller than the particle size of quantum dots that emit red light. Also, in quantum dots having the same core, the particle size of quantum dots that emit blue light may be smaller than the particle size of quantum dots that emit green light. However, the embodiment is not limited thereto, and even in quantum dots having the same core, the particle size may be adjusted depending on a material for forming a shell and a thickness of the shell. When the quantum dots have various light-emitting colors, such as blue, red, and green, the quantum dots having different light-emitting colors may have different core materials.

In an embodiment illustrated in FIG. 6, the first light-emitting layer EML-1 of the first light-emitting element ED1 may include red quantum dots, the second light-emitting layer EML-2 of the second light-emitting element ED2 may include green quantum dots, and the third light-emitting layer EML-3 of the third light-emitting element ED3 may include blue quantum dots.

In an embodiment, the hole transport regions HTR of the light-emitting elements ED1, ED2, and ED3 may include well-known hole transport materials. The hole transport region HTR may be formed by using various methods, such as a vacuum deposition method, a spin coating method, a casting method, a Langmuir-Blodgett (LB) method, an inkjet printing method, a laser printing method, and a laser-induced thermal imaging method.

The hole transport region HTR may have a single layer made of a single material, a single layer made of a plurality of different materials, or a multi-layer structure having a plurality of layers made of a plurality of different materials. The hole transport region HTR may include at least one of a hole injection layer, a hole transport layer, a buffer layer or a light-emitting auxiliary layer, or an electron-blocking layer.

The hole transport region HTR may include a phthalocyanine compound, such as copper phthalocyanine, N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4'4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalene-1-yl)-N,N'-diphenyl-benzidine (NPB), triphenylamine-containing polyether ketone (TPAPEK), 4-isopropyl-4'-methyldiphenyliodonium

[tetrakis(pentafluorophenyl)borate], and dipyrazino[2,3-f: 2',3'-h] quinoxaline-2,3,6,7,10,11-hexacarbonitrile (HATCN), etc.

The hole transport region HTR may include a carbazole-based derivative, such as N-phenylcarbazole and polyvinylcarbazole, a fluorene-based derivative, N,N'-bis(3-methylphenyl)-N,N'-diphenyl-[1,1'-biphenyl]-4,4'-diamine (TPD), a triphenylamine-based derivative, such as 4,4',4"-tris(N-carbazolyl)triphenylamine (TCTA), N,N'-di(naphthalene-1-yl)-N,N'-diphenyl-benzidine (NPB), 4,4'-Cyclohexylidene bis[N,N'-bis(4-methylphenyl)benzenamine] (TAPC), 4,4'-Bis[N,N'-(3-tolyl)amino]-3,3'-dimethylbiphenyl (HMTPD), 1,3-Bis(N-carbazolyl)benzene (mCP), etc.

Also, the hole transport region HTR may include 9-(4-tert-Butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), or etc.

In an embodiment, the electron transport region ETR of the light-emitting elements ED1, ED2, and ED3 may include well-known electron transport materials. The electron transport region ETR may be formed by using various methods, such as a vacuum deposition method, a spin coating method, a casting method, an LB method, an inkjet printing method, a laser printing method, and a laser-induced thermal imaging method.

The electron transport region ETR may have a single layer made of a single material, a single layer made of a plurality of different materials, or a multi-layer structure having a plurality of layers made of a plurality of different materials. The electron transport region ETR may include an electron transport layer and an electron injection layer that are staked on each other. Also, the electron transport region ETR may include at least one of a hole-blocking layer, an electron transport layer, a buffer layer, or an electron injection layer.

In an embodiment, the electron transport region ETR may include metal oxide. The electron transport region ETR may include at least one type of metal oxide, such as Li₂O, BaO, ZnO, ZnMgO, and MgO.

The electron transport region ETR may further include other well-known electron transport materials. For example, the electron transport region ETR may include tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-Biphenylyl)-4-phenyl-5-tert-butylphenyl-1,2,4-triazole (TAZ), 4-(Naphthalen-1-yl)-3,5-diphenyl-4H-1,2,4-triazole (NTAZ), 2-(4-Biphenylyl)-5-(4-tert-butylphenyl)-1,3,4-oxadiazole (tBu-PBD), bis(2-methyl-8-quinolinolato-N1,O8)-(1,1'-Biphenyl-4-olato)aluminium (BAlq), berylliumbis(benzoquinolin-10-olate) (Bebq₂), 9,10-di(naphthalene-2-yl)anthracene (ADN), 1,3-bis[3,5-di(pyridin-3-yl)phenyl]benzene (BmPyPhB), and a mixture thereof, or may include 8-hydroxyl-Lithium quinolate (Liq).

In addition, the electron transport region ETR may include halogenated metals, such as LiF, NaCl, CsF, RbCl, RbI, CuI, and KI, lanthanide metals, such as Yb, and co-deposited materials of the halogenated metals and the lanthanide metals. For example, the electron transport region ETR may include KI:Yb, RbI:Yb, LiF:Yb, or the like as the co-deposited material.

The electron transport region ETR may also include a mixture of an electron transport material and an insulating organo metal salt. The organo metal salt may include a material having an energy band gap of about 4 eV or more. Specifically, the organo metal salt may include, for example, metal acetate, metal benzoate, metal acetoacetate, metal acetylacetonate, or metal stearate.

In addition to the materials described above, the electron transport region ETR may include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen), but the embodiment is not limited thereto.

In an embodiment, the electron transport regions ETR in the light-emitting element ED1, ED2, and ED3 may include a material having high electrical conductivity. The electron transport region ETR is made of a material having high electrical conductivity. Accordingly, in the light-emitting elements ED1, ED2, and ED3 without a second electrode (or a common electrode), the electron transport region ETR may function as an electrode that receives an electrical signal supplied from a power line. For example, in the light-emitting elements ED1, ED2, and ED3, the electron transport region ETR may include ZnO, ZnMgO, or MgO.

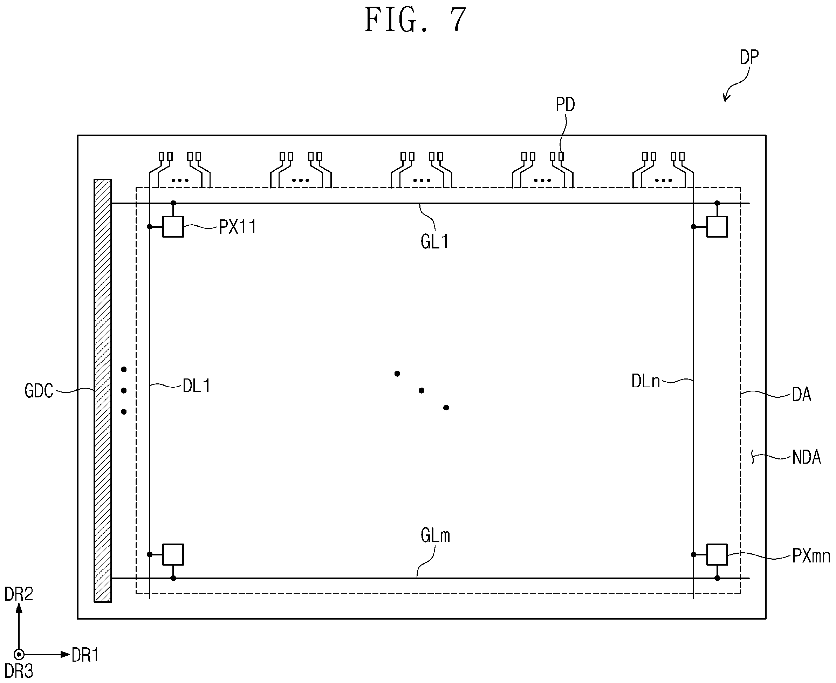

FIG. 7 is a plan view of a display panel according to an embodiment of the present disclosure. FIG. 7 illustrates the arrangement relationships of signal lines GL1 to GLm and DL1 to DLn and pixels PX11 to PXmn in a plan view among components of the display panel DP. The signal lines GL1 to GLm and DL1 to DLn may include a plurality of gate lines GL1 to GLm and a plurality of data lines DL1 to DLn.

The display panel DP may include a display region DA and a non-display region NDA. The non-display region NDA may be located on at least one side of the display region DA. The pixel regions PX11 to PXmn may be arranged in the display region DA, and some of the signal lines GL1 to GLm and DL1 to DLn or some of the regions may be arranged in the non-display region NDA. A gate driving circuit GDC connected to the gate lines GL1 to GLm may be located in the non-display region NDA.

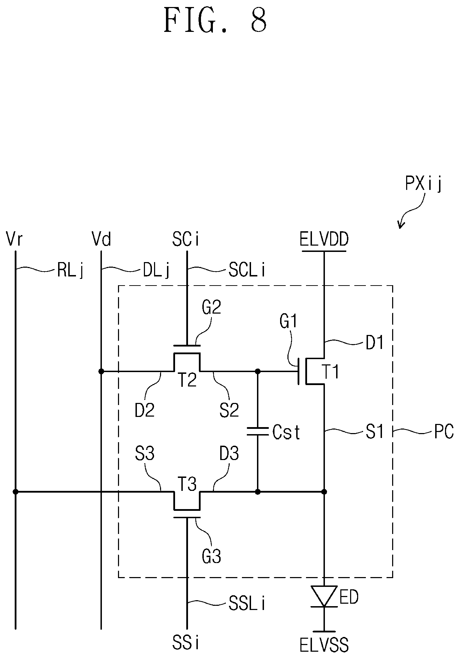

Each of the pixels PX11 to PXmn may be connected to a corresponding gate line among the plurality of gate lines GL1 to GLm and a corresponding data line among the plurality of data lines DL1 to DLn. Each of the pixels PX11 to PXmn may include a pixel driving circuit and a light-emitting element. Depending on the configuration of the pixel driving circuits of the pixels PX11 to PXmn, the display panel DP may be provided with more types of signal lines. For example, each of the gate lines GL1 to GLm may include a corresponding scan line SCLi (see FIG. 8) and a corresponding sensing line SSLi (see FIG. 8).

Referring to FIG. 7, in an embodiment, the gate driving circuit GDC may be located in the non-display region NDA, which is located on one side of the display region DA in the first direction DR1. Also, in an embodiment, pads PD connected to ends of the plurality of data lines DL1 to DLn may be arranged in the non-display region NDA, which is located on one side of the display region DA in the second direction DR2. However, this is only an example, and the embodiment is not limited thereto. The arrangement positions of the gate driving circuit GDC and the pads PD may vary.

FIG. 8 is an equivalent circuit diagram of a pixel according to an embodiment of the present disclosure. FIG. 8 illustrates an example of a pixel PXij that is connected to an i-th scan line SCLi, an i-th sensing line SSLi, a j-th data line DLj, and a j-th reference line RLj. The pixel PXij may include a pixel circuit PC and a light-emitting element ED connected to the pixel circuit PC. The pixel circuit PC may include a plurality of pixel transistors T1, T2, and T3 and at least one capacitor Cst.

FIG. 8 illustrates an example of the pixel circuit PC that includes the first pixel transistor T1, the second pixel transistor T2, the third pixel transistor T3, and the pixel capacitor Cst, but the configuration of the pixel circuit PC is not limited thereto.

In an embodiment, the first pixel transistor T1 may represent a drive transistor, and the second pixel transistor T2 may represent a switching transistor. Also, the third pixel transistor T3 may represent a sensing transistor. The pixel circuit PC may further include additional transistors in addition to the first to third pixel transistors T1, T2, and T3 or may further include additional capacitors in addition to the pixel capacitor Cst.

The light-emitting element ED may represent any of the first to third light-emitting elements ED1, ED2, and ED3 described above with reference to FIG. 6 or like. The pixel electrode AE (see FIG. 6) of the light-emitting element ED may receive a second voltage ELVDD via the first pixel transistor T1, and the electron transport region ETR of the light-emitting element ED may receive a first voltage ELVSS. The light-emitting element ED may emit light by receiving the first voltage ELVSS and the second voltage ELVDD.

The first pixel transistor T1 may include a drain D1 receiving the second voltage ELVDD, a source S1 connected to a pixel electrode of the light-emitting element ED, and a gate G1 connected to the pixel capacitor Cst. In response to a voltage value stored in the pixel capacitor Cst, the first pixel transistor T1 may control a drive current that flows through the light-emitting element ED from the second voltage ELVDD.

The second pixel transistor T2 may include a drain D2 connected to the j-th data line DLj, a source S2 connected to the pixel capacitor Cst, and a gate G2 receiving an i-th first scan signal SCi. The j-th data line DLj may receive a data voltage Vd. In response to the i-th first scan signal SCi, the second pixel transistor T2 may provide the data voltage Vd to the first pixel transistor T1.

The third pixel transistor T3 may include a source S3 connected to a j-th reference line RLj, a drain D3 connected to the pixel electrode of the light-emitting element ED, and a gate G3 receiving an i-th second scan signal SSi. The j-th reference line RLj may receive a reference voltage Vr. The third pixel transistor T3 may initialize the pixel electrodes of the capacitor Cst and the light-emitting element ED.

The pixel capacitor Cst may store a voltage corresponding to the difference between the voltage received from the second pixel transistor T2 and the second voltage ELVDD. The pixel capacitor Cst may be connected to the gate G1 of the first pixel transistor T1 and the pixel electrode of the light-emitting element ED.

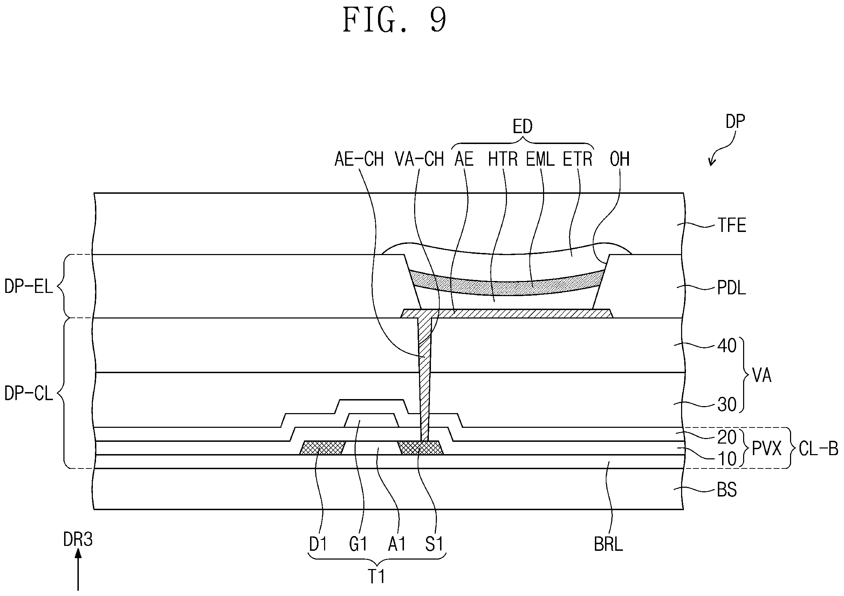

FIG. 9 is a cross-sectional view of a portion of a display panel according to an embodiment of the present disclosure. FIG. 9 illustrates only one light-emitting element ED and one transistor T1.

The circuit layer DP-CL may be disposed on the base layer BS, and the circuit layer DP-CL may include the transistor T1 as a circuit element. The configuration of the circuit layer DP-CL may vary depending on the design of a drive circuit of the pixel PXij (see FIG. 8), and in an embodiment, the circuit layer DP-CL may include a plurality of transistors having different functions.

In an embodiment, the transistor T1 shown in FIG. 9 may represent a drive transistor electrically connected to the light-emitting element ED. FIG. 9 illustrates an example of the arrangement relationships between the active A1, the source S1, the drain D1, and the gate G1 that constitute the transistor T1. The active A1, the source S1, and the drain D1 may be regions that are distinguishable from each other based on the doping concentration or conductivity of the semiconductor pattern.

The circuit layer DP-CL may include a lower buffer layer BRL, a lower insulating layer PVX, and an insulating layer VA that are disposed above the base layer BS. The lower insulating layer PVX may include a first insulating layer 10 and a second insulating layer 20. For example, in an embodiment, the lower buffer layer BRL, the first insulating layer 10, and the second insulating layer 20 may include inorganic layers. A layer including the inorganic layers of the lower buffer layer BRL, the first insulating layer 10, and the second insulating layer 20, and the transistor T1 may be referred to as a lower circuit layer CL-B.

The insulating layer VA may include a third insulating layer 30 and a fourth insulating layer 40. For example, in an embodiment, the third insulating layer 30 and the fourth insulating layer 40 may include organic layers. A plurality of openings may be defined in the insulating layer VA, and via the openings, a conductive pattern, a signal wire, or a transistor or the like of the lower circuit layer CL-B may be electrically connected to the light-emitting element ED or the like. FIG. 9 illustrates an example in which the light-emitting element ED is electrically connected to the transistor T1. The pixel electrode AE of the light-emitting element ED may be electrically connected to the source S1 of the transistor T1. A contact hole VA-CH passing through the insulating layer VA may be defined in the circuit layer DP-CL, and a contact portion AE-CH connecting the pixel electrode AE to the transistor T1 may be located in the contact hole VA-CH. FIG. 9 shows that the lower circuit layer CL-B includes the first and second insulating layers 10 and 20, and the insulating layer VA includes the third and fourth insulating layers 30 and 40, but the number of insulating layers in the circuit layer DP-CL may be less or more than that shown in FIG. 9. The number of inorganic insulating layers or organic insulating layers in the circuit layer DP-CL may vary depending on the arrangement characteristics of the conductive patterns that constitute the circuit layer DP-CL, a stack structure of signal wires or transistors, or the like.

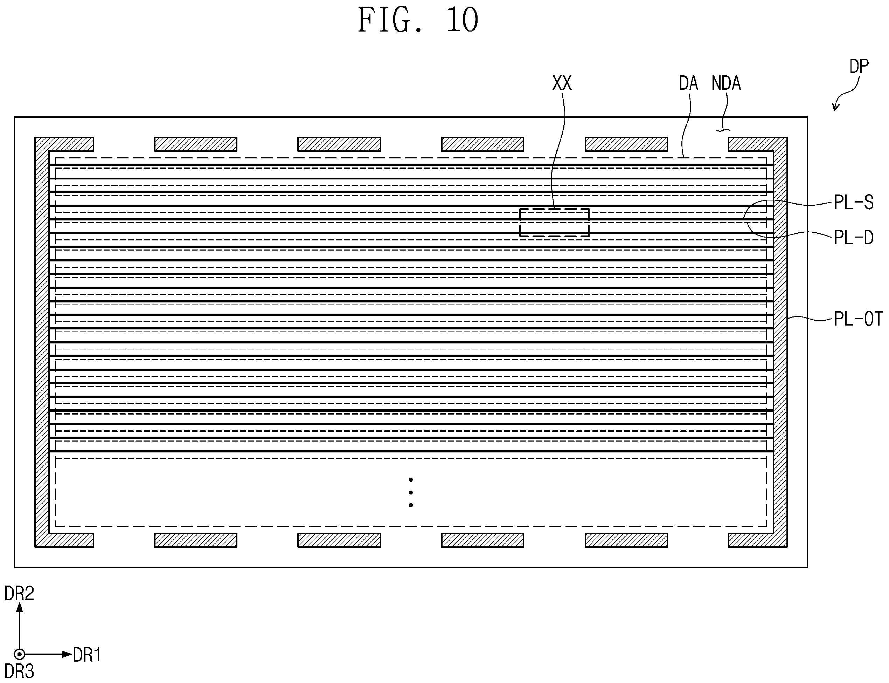

FIG. 10 is a plan view illustrating some components of a display panel according to an embodiment of the present disclosure. FIG. 10 illustrates only an example of the arrangement of voltage lines.

Referring to FIG. 10, the display panel DP may include a first voltage line PL-S and a second voltage line PL-D that provide different voltages. The first voltage line PL-S shown in FIG. 10 corresponds to the ELVSS voltage supply line described with reference to FIG. 8, and the second voltage line PL-D corresponds to the ELVDD voltage supply line described with reference to FIG. 8.

Referring to FIG. 10, the first voltage line PL-S and the second voltage line PL-D may be arranged entirely across the display region DA of the display panel DP. The first voltage line PL-S and the second voltage line PL-D may each extend in the first direction DR1. Also, a plurality of first voltage lines PL-S may be spaced apart from each other in the second direction DR2. A plurality of second voltage lines PL-D may also be spaced apart from each other in the second direction DR2. The first voltage lines PL-S and the second voltage lines PL-D may alternately repeat in the second direction DR2. However, the embodiment is not limited thereto, and the layout of the voltage lines may vary depending on the layout of the pixel regions, etc. However, the first voltage line PL-S and the second voltage line PL-D may be arranged inside the display region DA.

In the non-display region NDA of the display panel DP, an outer voltage line PL-OT may be located. The outer voltage line PL-OT may include a portion connected to the power module PM (see FIG. 1). The first voltage line PL-S may be connected to the outer voltage line PL-OT.

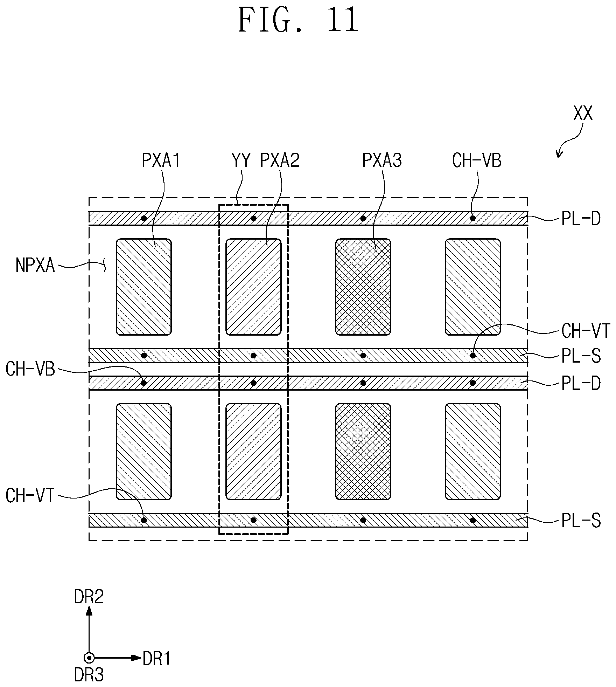

FIG. 11 is an enlarged plan view showing some regions of a display panel of the present disclosure. FIG. 11 may be a plan view of a region corresponding to region XX of FIG. 10.

FIG. 11 shows the layout of the pixel regions PXA1, PXA2, and PXA3 and the voltage lines PL-S and PL-D. Referring to FIG. 11, the first to third pixel regions PXA1, PXA2, and PXA3 may be arranged in the first direction DR1, and the voltage lines PL-S and PL-D may extend in the first direction DR1 while not overlapping the pixel regions PXA1, PXA2, and PXA3.

In the display panel according to an embodiment, the pixel regions PXA1, PXA2, and PXA3 may be arranged in a stripe form. A plurality of first pixel regions PXA1, a plurality of second pixel regions PXA2, and a plurality of third pixel regions PXA3 may each be aligned with each other along the second directional axis DR2. Also, the first pixel regions PXA1, the second pixel regions PXA2, and the third pixel regions PXA3 may be alternately arranged in this order along the first directional axis DR1.

The layout of the pixel regions PXA1, PXA2, and PXA3 is not limited to those shown in FIGS. 4 and 11. The order in which the first region PXA1, the second region PXA2, and the third region PXA3 are arranged may be provided in various combinations depending on the characteristics of the display quality required by the display module DM and the electronic device including the display module DM. For example, the pixel regions PXA1, PXA2, and PXA3 may be arranged in the form of PENTILE^{™} or Diamond Pixel^{™}. Also, depending on the layout of the pixel regions PXA1, PXA2, and PXA3, the arrangement of the voltage lines PL-S and PL-D may vary such that the voltage lines PL-S and PL-D are adjacent to each of the pixel regions PXA1, PXA2, and PXA3.

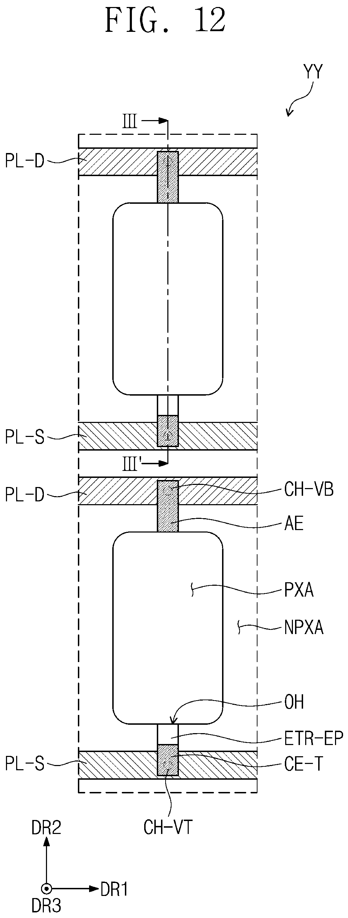

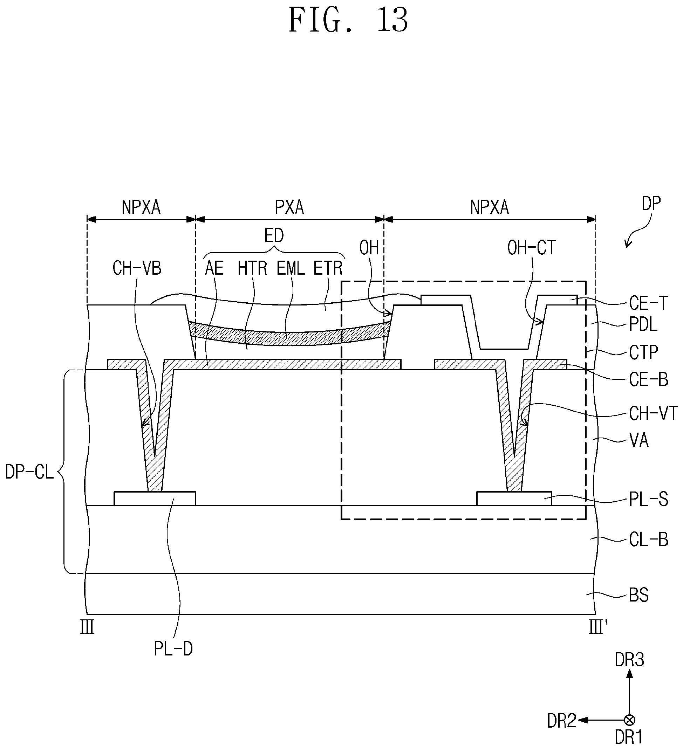

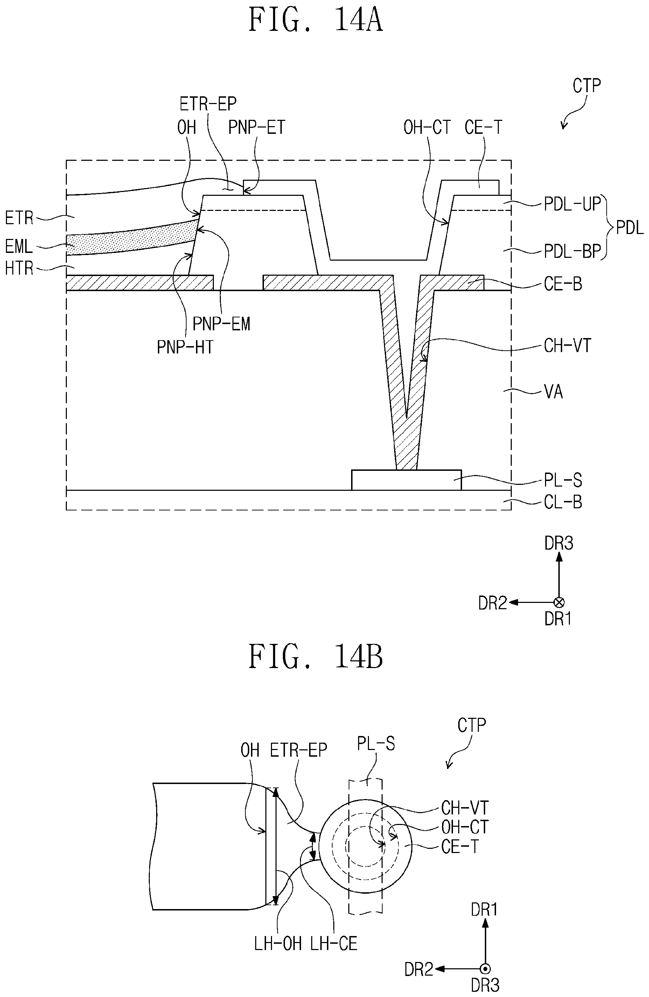

FIGS. 12 to 14B are diagrams illustrating a portion of a display panel according to an embodiment of the present disclosure. FIG. 12 is a plan view of a region corresponding to region YY of FIG. 11. FIG. 13 is a cross-sectional view of a region corresponding to line III-III' of FIG. 12. FIG. 14A is a cross-sectional view showing region "CTP" of FIG. 13 in more detail, and FIG. 14B is a plan view of region "CTP" of FIG. 13. Although FIGS. 12 to 14B illustrate one pixel region PXA and a portion of a peripheral region NPXA adjacent thereto, the description with reference to FIGS. 12 to 14B may equally apply to those of the first to third pixel regions PXA1, PXA2, and PXA3.

Referring to FIGS. 12 and 13, the circuit layer DP-CL may include a first voltage line PL-S, an insulating layer VA in which a first opening CH-VT is defined, and a lower contact electrode CE-B located in the first opening CH-VT and connected to the first voltage line PL-S. The circuit layer DP-CL may include a second voltage line PL-D disposed on the lower circuit layer CL-B. In the insulating layer VA, a second opening CH-VB may be defined. The first voltage line PL-S and the second voltage line PL-D are arranged separately from each other, and the first opening CH-VT and the second opening CH-VB may be defined so as not to overlap each other.

The display layer DP-EL is disposed on the circuit layer DP-CL and includes a pixel-defining layer PDL and a light-emitting element ED. The pixel-defining layer PDL has a contact opening OH-CT and a pixel opening OH. The pixel opening OH may define the pixel region PXA. The pixel region PXA may be defined as a region corresponding to the width of the pixel electrode AE exposed at the pixel opening OH. The contact opening OH-CT may be defined in the peripheral region NPXA.

At the contact opening OH-CT, at least a portion of the lower contact electrode CE-B is exposed. The lower contact electrode CE-B may have an electrode structure made of a metallic material, a metal alloy, or a conductive compound. The lower contact electrode CE-B may be formed in the same process as the pixel electrode AE. For example, the lower contact electrode CE-B may have the same composition of material as the pixel electrode AE. The lower contact electrode CE-B and the pixel electrode AE may each have a stack structure of ITO/Ag/ITO.

The pixel opening OH is defined so as not to overlap the contact opening OH-CT. The light-emitting element ED is located in the pixel opening OH.

The light-emitting element ED includes a pixel electrode AE exposed at the pixel opening OH, a hole transport region HTR disposed on the pixel electrode, a light-emitting layer EML disposed on the hole transport region, and an electron transport region ETR disposed on the light-emitting layer EML. In an embodiment, the electron transport region ETR of the light-emitting element ED is electrically connected to the lower contact electrode CE-B via the contact opening OH-CT. The pixel electrode AE of the light-emitting element ED may extend toward the second opening CH-VB defined in the insulating layer VA and may be located inside the second opening CH-VB. At the second opening CH-VB, the pixel electrode AE may be connected to the second voltage line PL-D.

Referring to FIGS. 12 and 13, in an embodiment, the pixel electrode AE of the light-emitting element ED located in the pixel region PXA may be extended and electrically connected to the second voltage line PL-D, and the electron transport region ETR of the light-emitting element ED may be extended and electrically connected to the first voltage line PL-S. A portion of the electron transport region ETR, which extends for electrical connection with the first voltage line PL-S, may be referred to as a contact region ETR-EP. The contact region ETR-EP may represent a portion of the electron transport region ETR of the light-emitting element ED located in each of the first to third pixel regions PXA1, PXA2, and PXA3, and this portion may extend toward the first voltage line PL-S adjacent thereto in the second direction DR2 intersecting the first direction DR1 along which the first to third pixel regions PXA1, PXA2, and PXA3 are arranged.

In an embodiment, the light-emitting element ED does not include an additional electrode that faces the pixel electrode AE with the light-emitting layer EML therebetween. The light-emitting element ED may not include any additional light-emitting structures made of a metal material, a metal alloy, or a conductive compound in addition to the pixel electrode AE. In an embodiment, the light-emitting element ED does not include a common electrode (or a cathode) that is provided in a light-emitting element according to the related art. That is, the only electrode of the light-emitting element ED is the pixel electrode AE. In an embodiment, the electron transport region ETR of the light-emitting element ED may be electrically connected to the first voltage line PL-S to receive the first voltage, and the pixel electrode AE may be electrically connected to the second voltage line PL-D to receive the second voltage, thereby emitting light.

The display panel DP according to an embodiment may include an upper contact electrode CE-T. The upper contact electrode CE-T may be in contact with the lower contact electrode CE-B and located in the contact opening OH-CT. The upper contact electrode CE-T may be located between the lower contact electrode CE-B and the electron transport region ETR. The upper contact electrode CE-T may electrically connect the lower contact electrode CE-B to the electron transport region ETR. The upper contact electrode CE-T may be made of the same material as the lower contact electrode CE-B. For example, the upper contact electrode CE-T may include a stack structure of ITO/Ag/ITO.

In an embodiment, the upper contact electrode CE-T may be arranged along the profile of the contact opening OH-CT and extend onto the pixel-defining layer PDL. The edge of the upper contact electrode CE-T may be located on the pixel-defining layer PDL. The upper contact electrode CE-T may be arranged while filling a portion of the first opening CH-VT that is not filled by the lower contact electrode CE-B. The upper contact electrode CE-T may be in contact with the lower contact electrode CE-B over a sufficient area.

Referring to FIGS. 13 to 14B, in an embodiment, one edge PNP-ET of the electron transport region ETR may be in contact with one edge of the upper contact electrode CE-T. The one edge PNP-ET of the electron transport region ETR may be in contact with the upper contact electrode CE-T above the pixel-defining layer PDL. That is, in an embodiment, the electron transport region ETR may extend in the direction from the pixel opening OH to the contact opening OH-CT. The contact region ETR-EP, which is an extension of the electron transport region ETR, may be in contact with the upper contact electrode CE-T that is located in the contact opening OH-CT.

In an embodiment, the hole transport region HTR and the light-emitting layer EML of the light-emitting element ED may be arranged inside the pixel opening OH, unlike the electron transport region ETR. An edge PNP-HT of the hole transport region HTR and an edge PNP-EM of the light-emitting layer EML may each be located on a side surface of the pixel-defining layer PDL. A side surface of the pixel-defining layer PDL is a surface parallel to the third direction DR3. Thus, the second direction DR2 is normal to the side surface of the pixel-defining layer PDL. The pixel-defining layer PDL may include an upper portion PDL-UP having relatively high liquid repellency and a lower portion PDL-BP disposed below the upper portion PDL-UP and having low liquid repellency, and the edge PNP-HT of the hole transport region HTR and the edge PNP-EM of the light-emitting layer EML may be located on the side surface of the lower portion PDL-BP of the pixel-defining layer PDL. On the other hand, the edge PNP-ET of the electron transport region ETR may be located at the upper portion PDL-UP that has relatively high liquid repellency in the pixel-defining layer PDL and may be in contact with the upper contact electrode CE-T above the pixel-defining layer PDL.

The positions of the edges of the hole transport region HTR, the light-emitting layer EML, and the electron transport region ETR of the light-emitting element ED may vary depending on the surface energy of materials provided to respectively form the hole transport region HTR, the light-emitting layer EML, and the electron transport region ETR. Depending on the surface energy of the materials provided to respectively form the hole transport region HTR, the light-emitting layer EML, and the electron transport region ETR, and the characteristics of liquid repellency of the pixel-defining layer PDL, the positions of the edges thereof may vary. The material of the electron transport region ETR having relatively high surface energy may be provided up to the upper portion PDL-UP having the high liquid repellency in the pixel-defining layer PDL and then fixed thereon. Also, the materials of the hole transport region HTR and the light-emitting layer EML having relatively low surface energy may not extend to the upper portion PDL-UP having the high liquid repellency in the pixel-defining layer PDL, and thus, the edges thereof may be formed at the lower portion PDL-BP having the relatively low liquid repellency in the pixel-defining layer PDL.

FIG. 14B illustrates that, in a plan view defined by the first directional axis DR1 and the second directional axis DR2, the area of the contact region ETR-EP of the electron transport region ETR gradually decreases in the direction from the pixel opening OH toward the contact opening OH-CT. Referring to FIG. 14B, a length LH-OH of the contact region ETR-EP overlapping the edge of the pixel opening OH may be greater than a contact length LH-CE of the contact region ETR-EP contacting the upper contact electrode CE-T on the side of the contact opening OH-CT.

However, the embodiment of the present disclosure is not limited thereto. The shape of the contact region ETR-EP in a plan view may be modified such that the contact region ETR-EP is in contact with the edge of the upper contact electrode CE-T over a larger area, unlike that shown in FIG. 14B. The contact length LH-CE of the contact region ETR-EP in contact with the upper contact electrode CE-T may be greater than that shown in FIG. 14B, etc. For example, the contact length LH-CE of the contact region ETR-EP may be similar to or greater than the length LH-OH of the contact region ETR-EP that overlaps the edge of the pixel opening OH.

The length LH-OH of the contact region ETR-EP is not particularly limited, provided that the contact region ETR-EP is in electrically stable contact with the upper contact electrode CE-T. For example, the length LH-OH of the contact region ETR-EP may be about 3 µm or more. However, even when the electron transport regions ETR extend, the electron transport regions ETR of the light-emitting elements ED1, ED2, and ED3 (see FIG. 6) located respectively in the pixel regions PXA1, PXA2, and PXA3 are not connected to each other, and the electron transport regions ETR of the light-emitting elements ED1, ED2, and ED3 (see FIG. 6) may be respectively connected to the voltage lines via the contact openings adjacent to the pixel regions PXA1, PXA2, and PXA3.

In an embodiment described with reference to FIGS. 11 to 14B, the light-emitting element in the display module may include a pixel electrode, a hole transport region, a light-emitting layer, an electron transport region, and may not include any additional electrodes. Accordingly, the electron transport region may be electrically connected to the voltage line. In the display module according to an embodiment, a voltage line supplying voltage to a light-emitting element may be located in a display region, and the voltage line and the light-emitting element may be electrically connected to each other at a location adjacent to each of the light-emitting elements.

Accordingly, in the display module according to an embodiment, the voltage drop difference due to the difference in the distance between the light-emitting element and the voltage line may be reduced. In the display module according to an embodiment, each of the light-emitting elements may be connected to the voltage line via the contact opening defined at a position adjacent to the light-emitting element and may receive the voltage. The difference in the IR voltage drops depending on the locations of a central portion or a peripheral portion of the display region is reduced, which may provide excellent electrical characteristics and reliability. Table 1 below shows the results of simulation (CAE simulation) evaluation of the voltage drop in a display module including a common electrode according to the related art and in the display module not including the common electrode according to the disclosed subject matter of the present disclosure. In Table 1, a comparative example shows the display module according to the related art, in which the light-emitting element includes a common electrode disposed on the electron transport region across the pixel regions, in contrast with those of the disclosed subject matter. In Table 1, the comparative example and the embodiment of the present disclosure are all evaluated and compared based on a display module having a size of about 12.4". The voltage drop in the comparative example versus that of the embodiment of the present disclosure is evaluated with all other conditions being the same, except for the presence or absence of the common electrode.

In the comparative example evaluated in Table 1, the common electrode has sheet resistance of about 15 Ω/cm². In contrast, in the embodiment of the present disclosure, the sheet resistance of the first voltage line (the ELVSS wire) extending to the display region is about 0.05 Ω/cm², the contact resistance between the electron transport region and the contact electrodes (the upper contact electrode and the lower contact electrode) is about 10⁻⁴ Ω/cm², and the sheet resistance of the electron transport region is about 0.4 Ω/cm². It is noted that for both the comparative example and the embodiment of the present disclosure, the electron transport region is made of ZnO.

**[Table 1]**

| Classification | Comparative Example | Embodiment |
|---|---|---|
| IR Drop(V) | 4.25 | < 0.2 |

Referring to the results in Table 1, it can be seen that the IR drop is significantly reduced in the embodiment of the present disclosure when compared to that of the comparative example. Also, in the light-emitting element in the display module according to an embodiment, the electron transport region may have a function of receiving a voltage, unlike in the light-emitting element according to the related art, and thus, the light-emitting element according to the embodiment may not include a common electrode (or a second electrode facing the pixel electrode). Accordingly, economic efficiency of the process may be improved by omitting processes such as deposition for forming a common electrode.

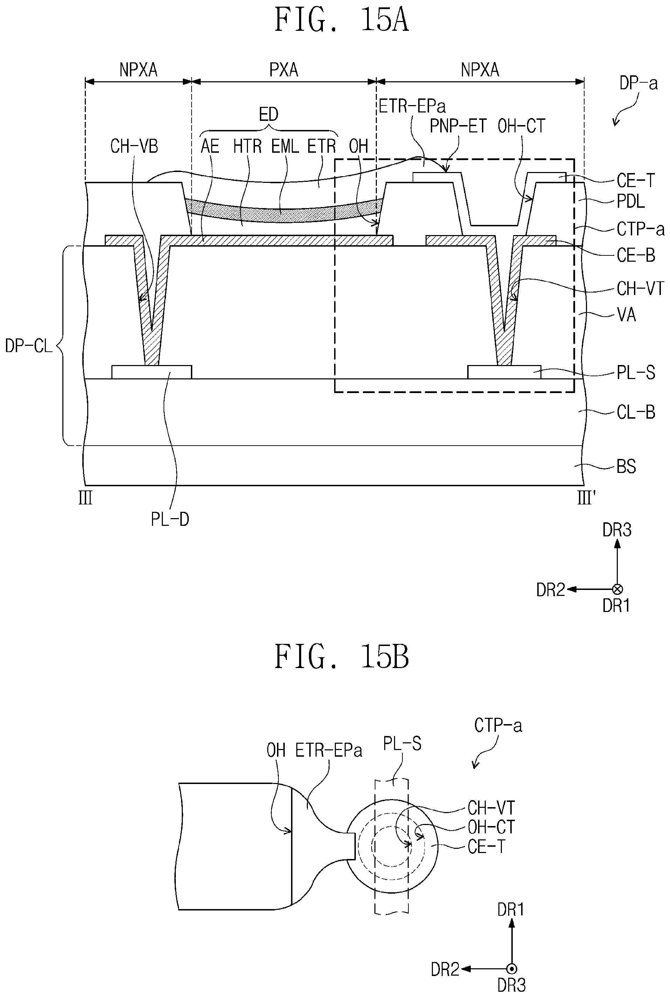

FIGS. 15A and 15B are diagrams illustrating a portion of a display panel according to an embodiment of the present disclosure. FIG. 15A is a cross-sectional view of a region corresponding to line III-III' of FIG. 12, and FIG. 15B is a plan view showing region CTP-a of FIG. 15A.

The display panel DP-a according to an embodiment described with reference to FIGS. 15A and 15B is different from the display panel DP according to an embodiment described with reference to FIGS. 13 to 14B in terms of the position of the edge PNP-ET of the electron transport region.

The electron transport region ETR may overlap at least a portion of the upper contact electrode CE-T. A contact region ETR-EPa, which is a portion of the electron transport region ETR extending toward the contact opening OH-CT, may overlap the upper contact electrode CE-T. The edge PNP-ET of the electron transport region ETR may be disposed on the upper contact electrode CE-T. In the display panel DP-a according to an embodiment shown in FIG. 15A, the edge PNP-ET of the electron transport region ETR may be located above the upper contact electrode CE-T on the pixel-defining layer PDL, and the edges of the hole transport region HTR and the light-emitting layer EML may be located inside the pixel opening OH.

Referring to FIG. 15B, in a plan view defined by the first directional axis DR1 and the second directional axis DR2, the contact region ETR-EPa may extend in the direction from the pixel opening OH toward the contact opening OH-CT and may overlap at least a portion of the upper contact electrode CE-T.

FIG. 15B also illustrates that the area of the contact region ETR-EPa of the electron transport region ETR gradually decreases from the pixel opening OH toward the contact opening OH-CT, but the embodiment of the present disclosure is not limited thereto. For example, the shape of the contact region ETR-EPa in a plan view may be modified such that the contact region ETR-EPa overlaps the edge of the upper contact electrode CE-T over a larger area, unlike that shown in FIG. 15B.

In the display panel DP-a according to an embodiment, the contact area between the electron transport region ETR and the upper contact electrode CE-T may be further increased. Accordingly, the light-emitting element may more stably receive the voltage supplied by the voltage line, thereby increasing electrical reliability.

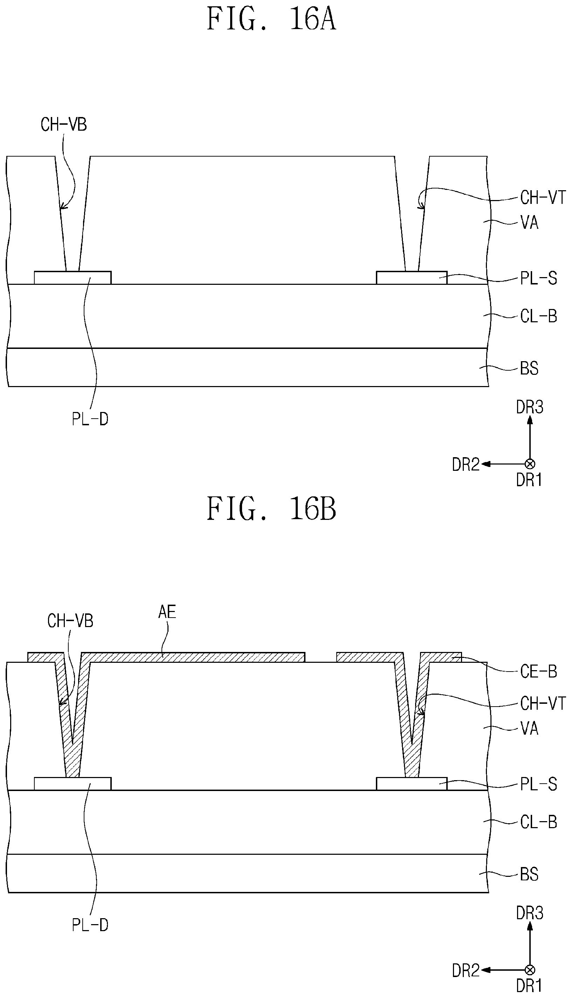

FIGS. 16A to 16F are diagrams illustrating example steps of manufacturing a display module according to an embodiment of the present disclosure. The display module, including the display panel, according to an embodiment described with reference to FIG. 13 may be manufactured in accordance with the method for manufacturing a display module described with reference to FIGS. 16A to 16F.

FIG. 16A illustrates example steps of forming an opening in an insulating layer included in a circuit layer. Referring to FIG. 16A, the lower circuit layer CL-B may be disposed on the base layer BS, and the first voltage line PL-S and the second voltage line PL-D may be disposed on the lower circuit layer CL-B. The insulating layer VA may cover the first voltage line PL-S and the second voltage line PL-D and may be disposed on the lower circuit layer CL-B. The first opening CH-VT and the second opening CH-VB may be defined in the insulating layer VA. The first opening CH-VT may be defined so as to expose at least a portion of the first voltage line PL-S, and the second opening CH-VB may be defined so as to expose at least a portion of the second voltage line PL-D.

FIG. 16B is a diagram illustrating example steps of forming electrodes arranged in the openings CH-VT and CH-VB of the insulating layer VA. Referring to FIG. 16B, the lower contact electrode CE-B may be located in the first opening CH-VT, and the pixel electrode AE may extend to the second opening CH-VB.

The lower contact electrode CE-B may be disposed in the first opening CH-VT while bending along the shape thereof. The lower contact electrode CE-B may be connected to the first voltage line PL-S that is exposed at the first opening CH-VT. The lower contact electrode CE-B may be arranged along the shape of the first opening CH-VT and extend from the first opening CH-VT onto the upper surface of the insulating layer VA.

The pixel electrode AE may be disposed in the second opening CH-VB while bending along the shape thereof. The pixel electrode AE may be connected to the second voltage line PL-D that is exposed at the second opening CH-VB. The pixel electrode AE may be arranged along the shape of the second opening CH-VB and extend from the second opening CH-VB onto the upper surface of the insulating layer VA. The pixel electrodes AE may extend over a sufficient area on the insulating layer VA so as to overlap other functional layers of the light-emitting element.

The lower contact electrode CE-B and the pixel electrode AE may each be patterned to have the structure of ITO/Ag/ITO.

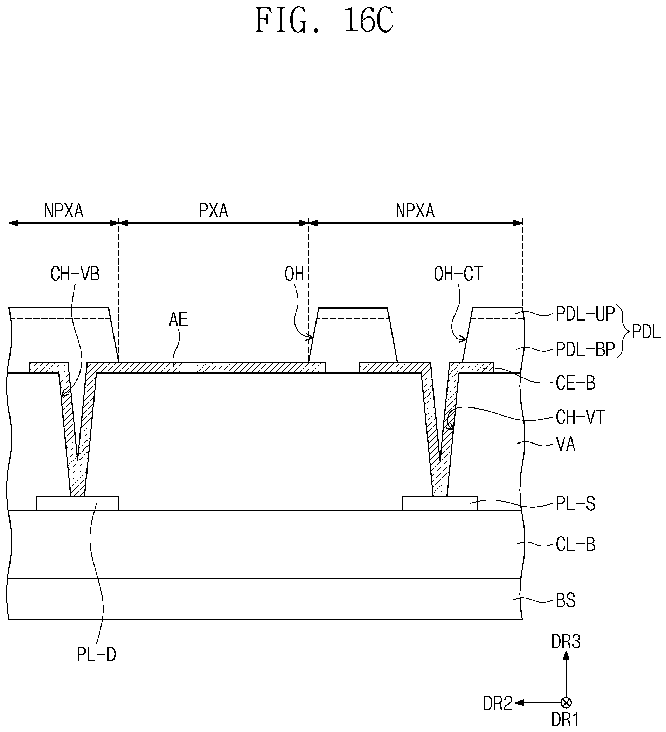

FIG. 16C is a diagram illustrating example steps of forming a pixel-defining layer. The pixel opening OH and the contact opening OH-CT may be defined in the pixel-defining layer PDL. The upper surface of the pixel electrode AE may be exposed at the pixel opening OH, and the lower contact electrode CE-B may be exposed at the contact opening OH-CT. The pixel opening OH defined in the pixel-defining layer PDL may define the pixel region PXA.

The pixel-defining layer PDL may fill the second opening CH-VB that exposes the second voltage line PL-D. The pixel opening OH may be defined adjacent to the second opening CH-VB, but not overlapping the second opening CH-VB.

Also, the pixel-defining layer PDL may be disposed such that the lower contact electrode CE-B is exposed. The contact opening OH-CT may be defined to overlap the first opening CH-VT. The contact opening OH-CT may be defined such that the pixel-defining layer PDL is not disposed on the lower contact electrode CE-B located in the first opening CH-VT.

The pixel-defining layer PDL may include a liquid-repellent material. In the pixel-defining layer PDL, the upper portion PDL-UP may have higher liquid repellency than the lower portion PDL-BP. The fluorine (F) component, which exhibits liquid repellency, may be distributed relatively more in the upper portion PDL-UP of the pixel-defining layer PDL. Accordingly, the upper surface of the pixel-defining layer PDL may have higher liquid repellency than the side surfaces of the pixel-defining layer PDL. The contact angle of a methylethylbenzene (MEB) solution on the upper portion PDL-UP of the pixel-defining layer PDL including the liquid-repellent material may be greater than or equal to about 55 degrees.

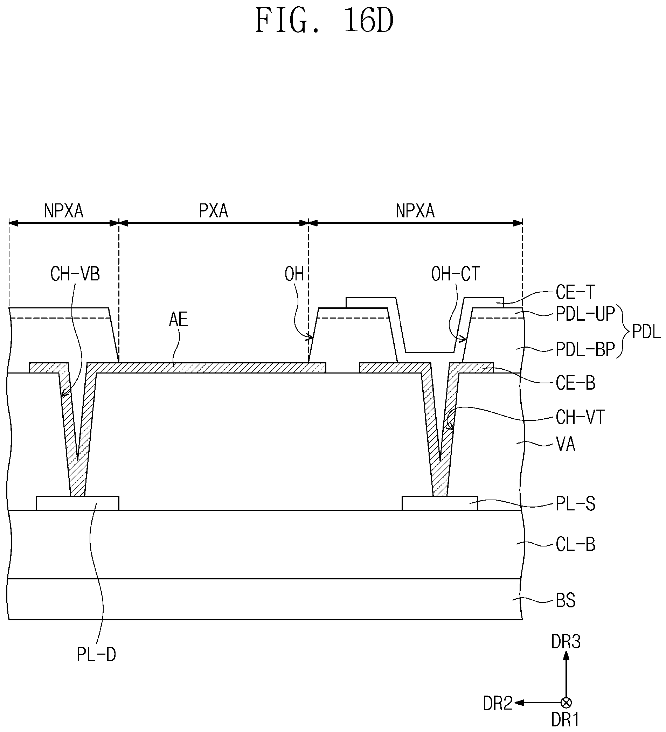

FIG. 16D is a diagram illustrating example steps of forming an upper contact electrode. The upper contact electrode CE-T may be located inside the contact opening OH-CT. In the contact opening OH-CT, the upper contact electrode CE-T may be in contact with the lower contact electrode CE-B. A portion of the first opening CH-VT, which is not filled by the lower contact electrode CE-B, may be filled by the upper contact electrode CE-T. The upper contact electrode CE-T may extend to the side surface of the pixel-defining layer PDL and the upper surface of the pixel-defining layer PDL along the shape of the contact opening OH-CT.

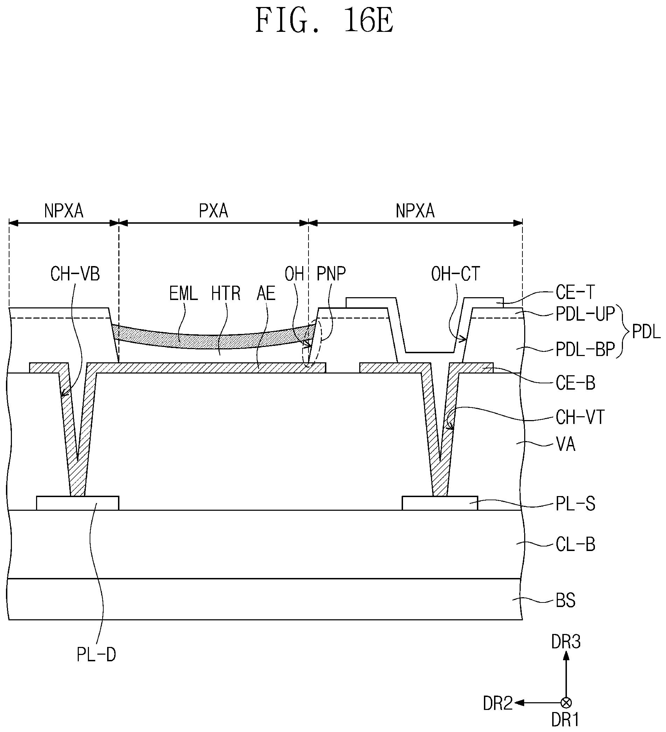

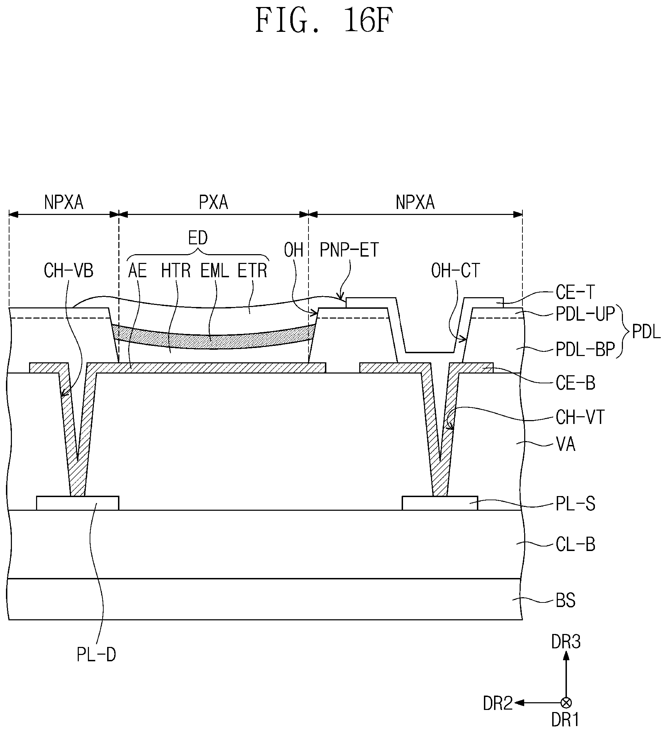

FIGS. 16E and 16F are diagrams illustrating example steps of providing functional layers of a light-emitting element according to an embodiment of the present disclosure. FIG. 16E illustrates a step of sequentially providing the hole transport region HTR and the light-emitting layer EML on the pixel electrode AE. The hole transport region HTR and the light-emitting layer EML may be located inside the pixel opening OH. Edges PNP of the hole transport region HTR and the light-emitting layer EML may be located on the side surface of the pixel-defining layer PDL. In an embodiment, the edges PNP of the hole transport region HTR and the light-emitting layer EML may be located on the side surface of the lower portion PDL-BP of the pixel-defining layer.

FIG. 16F illustrates example steps of forming the electron transport region ETR. The electron transport region ETR may be provided on the light-emitting layer EML, and the edge PNP-ET of the electron transport region ETR may extend partially onto the pixel-defining layer PDL. The electron transport region ETR may be formed such that the edge PNP-ET on one side of the electron transport region ETR is in contact with the upper contact electrode CE-T.

The hole transport region HTR, the light-emitting layer EML, and the electron transport region ETR may each be provided by a printing method. The printing material for forming the hole transport region HTR and the light-emitting layer EML may have less surface energy than the printing material for forming the electron transport region ETR. For example, the contact angle on the printing material for forming the hole transport region HTR and the light-emitting layer EML may be about 40 degrees (°) or more, and the contact angle on the printing material for forming the electron transport region ETR may be about 20 degrees (°) or less. Accordingly, the hole transport region HTR and the light-emitting layer EML may not extend onto the upper portion PDL-UP of the pixel-defining layer, which has relatively high liquid repellency, but may be placed only inside the pixel opening OH. Also, the electron transport region ETR having high surface energy may extend onto the upper portion PDL-UP of the pixel-defining layer having high liquid repellency, and thus, the electron transport region ETR and the upper contact electrode CE-T may be in contact with each other on the pixel-defining layer PDL. The contact angle of the printing material described above corresponds to the contact angle on an ITO surface.

FIGS. 16A to 16F illustrate an example method of manufacturing a display module having a structure of the display panel DP according to an embodiment described with reference to FIG. 13, etc. However, the manufacturing method described with reference to FIGS. 16A to 16B may also apply to the method of manufacturing a display module having a structure of the display panel DP-a according to an embodiment described with reference to FIG. 15A, etc. However, in this case, in the step of forming the electron transport region described with reference to FIG. 16F, the electron transport region ETR may extend to overlap an upper contact electrode CE-T.

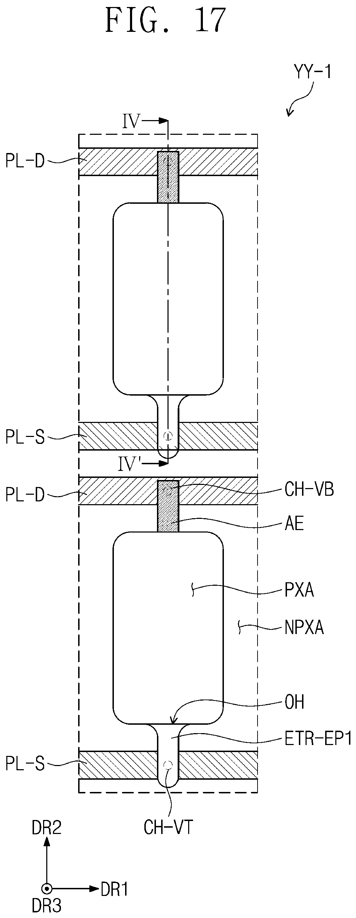

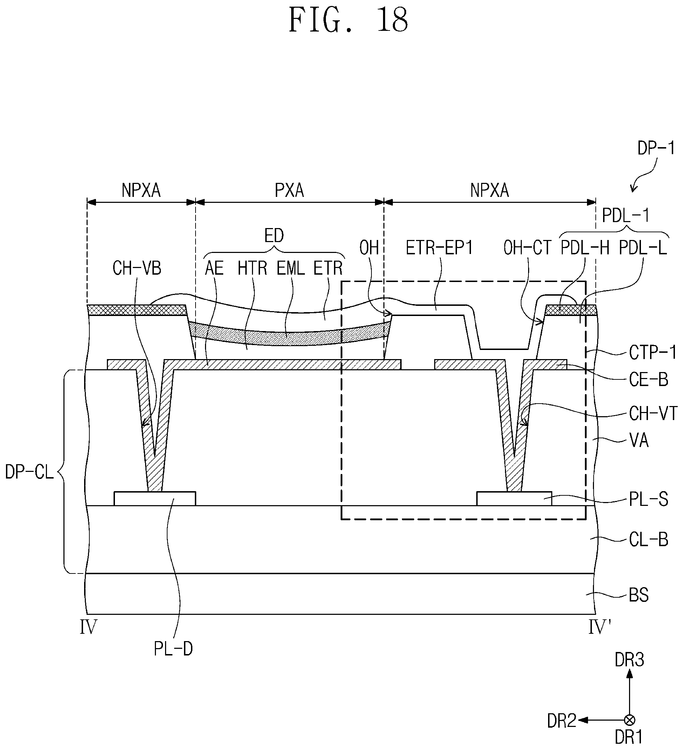

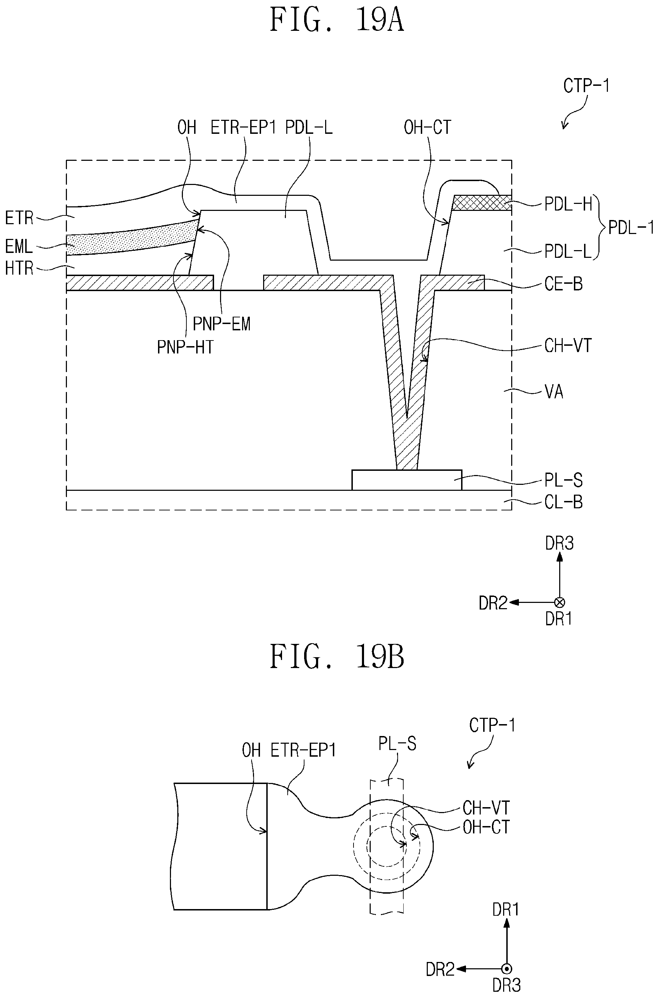

FIGS. 17 to 19B are diagrams illustrating a portion of a display panel according to an embodiment, which is included in a display module according to an embodiment. FIG. 17 is a plan view of region YY-1 corresponding to region YY of FIG. 11. FIG. 18 is a cross-sectional view of a region corresponding to line IV-IV' of FIG. 17. FIG. 19A is a cross-sectional view showing region "CTP-1" of FIG. 18 in more detail, and FIG. 19B is a plan view of region "CTP-1" of FIG. 18. When describing the display module according to an embodiment with reference to FIGS. 17 to 19B, the repeated descriptions as those given above with reference to FIGS. 1 to 16F are omitted and the differences therebetween are mainly described.

The display panel DP-1 according to an embodiment described with reference to FIGS. 17 to 19B differs from the display panel DP of FIG. 13 and the display panel DP-a of FIG. 15A in terms of the arrangement of the electron transport region ETR.

In the display panel DP-1 according to an embodiment, the electron transport region ETR may extend into the contact opening OH-CT and come into direct contact with the lower contact electrode CE-B. In the display panel DP-1 according to an embodiment, the upper contact electrode CE-T (see FIG. 13) may be omitted.

A contact region ETR-EP1 of the electron transport region ETR may extend toward the first voltage line PL-S located adjacent thereto in the second direction DR2 and may be arranged to overlap the first voltage line PL-S.

The display panel DP-1 according to an embodiment also differs from the display panel DP of FIG. 13 and the display panel DP-a of FIG. 15A in terms of the configuration of the pixel-defining layer. In the display panel DP-1 according to an embodiment, a pixel-defining layer PDL-1 may include a first pixel-defining portion PDL-L disposed directly on the insulating layer VA and a second pixel-defining portion PDL-H disposed on the first pixel-defining portion PDL-L. The second pixel-defining portion PDL-H may have higher liquid repellency than the first pixel-defining portion PDL-L. The upper surface of the second pixel-defining portion PDL-H may have liquid repellency. The upper surface of the second pixel-defining portion (PDL-H) may have a high fluorine (F) content, which corresponds to the liquid-repellent component.

In an embodiment illustrated in FIG. 18, the pixel-defining layer PDL-1 may include only the first pixel-defining portion PDL-L in some regions and may have a stack structure of the first pixel-defining portion PDL-L and the second pixel-defining portion PDL-H in other regions.

Referring to FIG. 18, the pixel-defining layer PDL-1, which is located between the pixel opening OH and the contact opening OH-CT and completely overlaps the electron transport region ETR, may include only the first pixel-defining portion PDL-L. The second pixel-defining portion PDL-H may be omitted in the pixel-defining layer PDL-1 that is located between the pixel opening OH and the contact opening OH-CT and completely overlaps the electron transport region ETR. Accordingly, the electron transport region ETR may extend along the upper surface of the first pixel-defining portion PDL-L and extend into the contact opening OH-CT. The electron transport region ETR extending into the contact opening OH-CT may extend onto the upper surface of the stack structure of the first pixel-defining portion PDL-L and the second pixel-defining portion PDL-H defining the contact opening OH-CT. Accordingly, the electron transport region ETR and the lower contact electrode CE-B may be in sufficient contact with each other inside the contact opening OH-CT.

In an embodiment, an edge PNP-HT of the hole transport region HTR and an edge PNP-EM of the light-emitting layer EML may be located on a side surface of the first pixel-defining portion PDL-L. The electron transport region ETR may cover the upper surface of the exposed first pixel-defining portion PDL-L without the second pixel-defining portion PDL-H on the upper surface thereof, and an edge of the electron transport region ETR may be located on the upper surface of the second pixel-defining portion PDL-H.

In FIG. 19B, in a plan view defined by the first directional axis DR1 and the second directional axis DR2, the contact region ETR-EP1 of the electron transport region ETR may be arranged to sufficiently cover the contact opening OH-CT along the shape of the contact opening OH-CT. However, the shape of the contact region ETR-EP1 in a plan view is not limited thereto. The shape of the contact region in a plan view may freely vary, provided that the shape thereof sufficiently covers the contact opening OH-CT.

However, even when the electron transport regions ETR extend, the electron transport regions ETR of the light-emitting elements ED1, ED2, and ED3 (see

FIG. 11) located respectively in the pixel regions PXA1, PXA2, and PXA3 (see FIG. 6) are not connected to each other, and the electron transport regions ETR of the light-emitting elements ED1, ED2, and ED3 (see FIG. 6) may be respectively connected to the voltage lines via the contact openings adjacent to the pixel regions PXA1, PXA2, and PXA3 (see FIG. 11).

In the display panel DP-1 according to an embodiment, the contact region ETR-EP1 of the electron transport region ETR is in contact with the lower contact electrode CE-B over a sufficient contact area at the contact opening OH-CT, and thus, the stability of the electrical connection between the electron transport region ETR and the first voltage line PL-S may increase. In an embodiment, the electron transport region ETR of the light-emitting element ED may include metal oxide or the like having high electrical conductivity, and thus, the sufficient electrical characteristics for receiving voltage may be achieved by the electron transport region ETR alone. Accordingly, the light-emitting element may more stably receive the voltage supplied by the voltage line, thereby increasing electrical reliability. Furthermore, in the display panel DP-1 according to an embodiment, the upper contact electrode CE-T may be further omitted. Therefore, economic efficiency of the process in manufacturing the display module may be further improved.

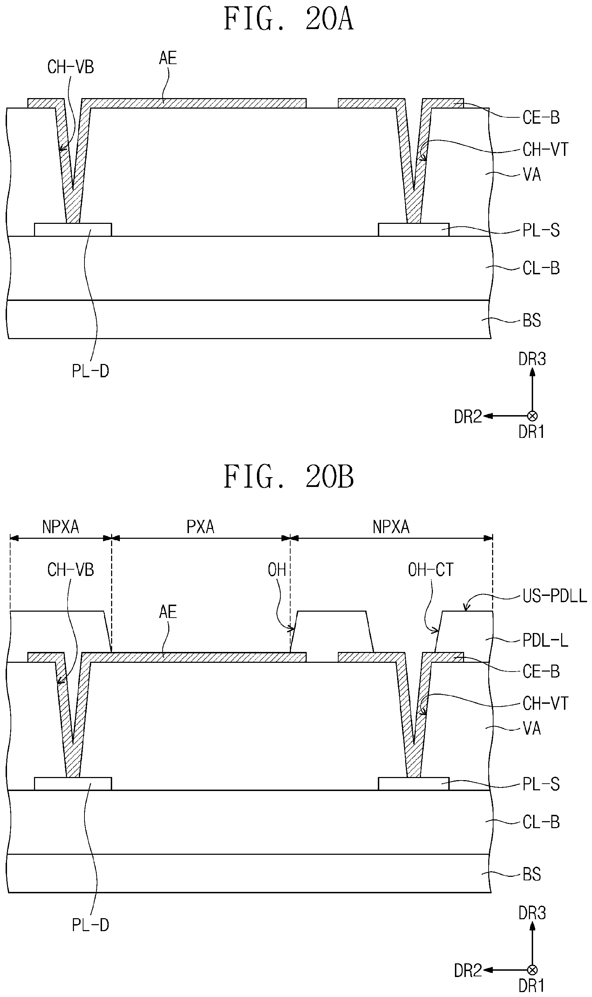

FIGS. 20A to 20F are diagrams illustrating example steps of manufacturing a display module according to an embodiment of the present disclosure. The display module, including the display panel according to an embodiment described with reference to FIG. 18, may be manufactured using the steps in the method for manufacturing a display module according to an embodiment described with reference to FIGS. 20A to 20F. When describing a method for manufacturing the display module according to an embodiment with reference to FIGS. 20A to 20F, the repeated descriptions as the method for manufacturing the display module according to an embodiment with reference to FIGS. 16A to 16F are omitted and the description below includes mainly the differences therebetween.

FIG. 20A illustrates example steps of forming an opening in an insulating layer included in a circuit layer. Referring to FIG. 20A, the lower circuit layer CL-B may be disposed on the base layer BS, and the first voltage line PL-S and the second voltage line PL-D may be disposed on the lower circuit layer CL-B. The insulating layer VA may cover the first voltage line PL-S and the second voltage line PL-D and may be disposed on the lower circuit layer CL-B. The first opening CH-VT and the second opening CH-VB may be defined in the insulating layer VA. The first opening CH-VT may be defined so as to expose at least a portion of the first voltage line PL-S, and the second opening CH-VB may be defined so as to expose at least a portion of the second voltage line PL-D.

FIG. 20B is a diagram illustrating example steps of forming electrodes disposed in the openings CH-VT and CH-VB of the insulating layer VA and subsequently forming the first pixel-defining portion PDL-L. Referring to FIG. 20B, the lower contact electrode CE-B may be located in the first opening CH-VT, and the pixel electrode AE may extend to the second opening CH-VB.

The lower contact electrode CE-B may be connected to the first voltage line PL-S that is exposed at the first opening CH-VT. The lower contact electrode CE-B may be arranged along the shape of the first opening CH-VT and extend from the first opening CH-VT onto the upper surface of the insulating layer VA.

The pixel electrode AE may be connected to the second voltage line PL-D that is exposed at the second opening CH-VB. The pixel electrode AE may be arranged along the shape of the second opening CH-VB and extend from the second opening CH-VB onto the upper surface of the insulating layer VA. The lower contact electrode CE-B and the pixel electrode AE may each be patterned to have the structure of ITO/Ag/ITO.

The pixel opening OH and the contact opening OH-CT may be defined in the first pixel-defining portion PDL-L. The upper surface of the pixel electrode AE may be exposed at the pixel opening OH, and the lower contact electrode CE-B may be exposed at the contact opening OH-CT. The pixel opening OH defined in the first pixel-defining portion PDL-L may define the pixel region PXA.

The upper surface of the first pixel-defining portion PDL-L may exhibit relatively high liquid repellency compared to the side surface of the first pixel-defining portion PDL-L. The first pixel-defining portion PDL-L may include a liquid-repellent material. The upper portion of the first pixel-defining portion PDL-L may have higher liquid repellency than the lower portion thereof. The fluorine (F) component, which exhibits liquid repellency, may be distributed relatively abundantly on the upper surface of the first pixel-defining portion PDL-L. The contact angle of a methylethylbenzene (MEB) solution on the upper surface of the first pixel-defining portion PDL-L including the liquid-repellent material may be from about 45 degrees to about 55 degrees.

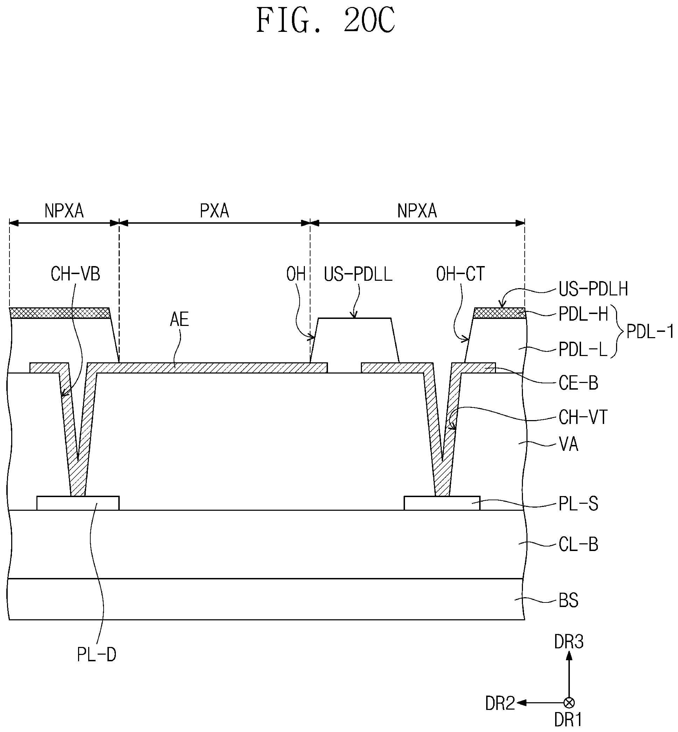

FIG. 20C is a diagram illustrating example steps of forming the second pixel-defining portion PDL-H. The second pixel-defining portion PDL-H may be formed on the first pixel-defining portion PDL-L. An upper surface US-PDLH of the second pixel-defining portion PDL-H may exhibit relatively high liquid repellency compared to the first pixel-defining portion PDL-L. The second pixel-defining portion PDL-H may include a liquid-repellent material. The second pixel-defining portion PDL-H may have higher liquid repellency than the first pixel-defining portion PDL-L. The fluorine (F) component, which exhibits liquid repellency, may be distributed relatively abundantly on the upper surface of the second pixel-defining portion PDL-H. The contact angle of a methylethylbenzene (MEB) solution on the upper surface US-PDLH of the second pixel-defining portion PDL-H including the liquid-repellent material may be greater than or equal to about 65 degrees.

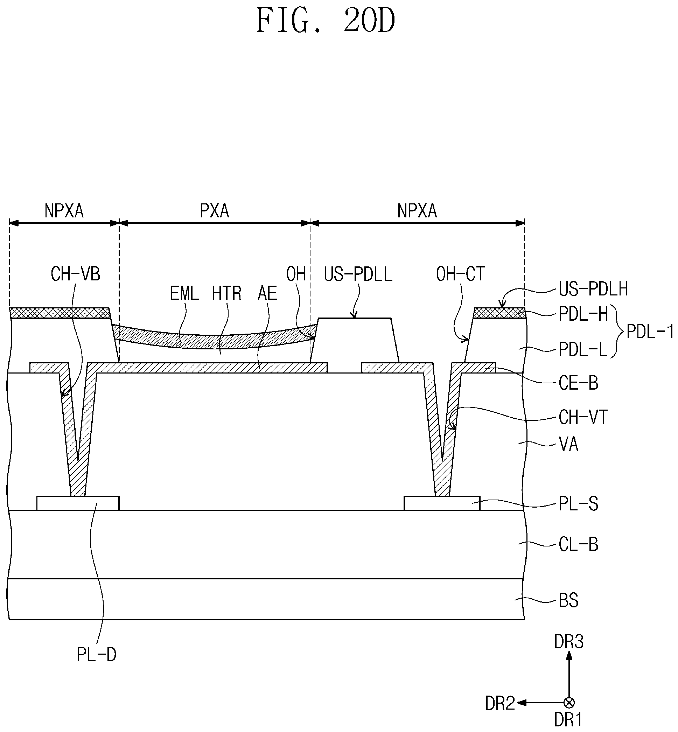

FIG. 20D is a diagram illustrating example steps of providing functional layers of a light-emitting element. FIG. 20D illustrates a step of sequentially providing the hole transport region HTR and the light-emitting layer EML on the pixel electrode AE. The hole transport region HTR and the light-emitting layer EML may be located inside the pixel opening OH. The hole transport region HTR and the light-emitting layer EML may be disposed inside the pixel opening OH defined by the first pixel-defining portion PDL-L. The edges of the hole transport region HTR and the light-emitting layer EML may be located on the side surface of the first pixel-defining portion PDL-L. In an embodiment, an upper surface US-PDLL of the first pixel-defining portion PDL-L may have higher liquid repellency than the side surface of the first pixel-defining portion PDL-L. Accordingly, the hole transport region HTR and the light-emitting layer EML may not extend onto the upper surface US-PDLL of the first pixel-defining portion PDL-L, but may be located inside the first pixel-defining portion PDL-L.

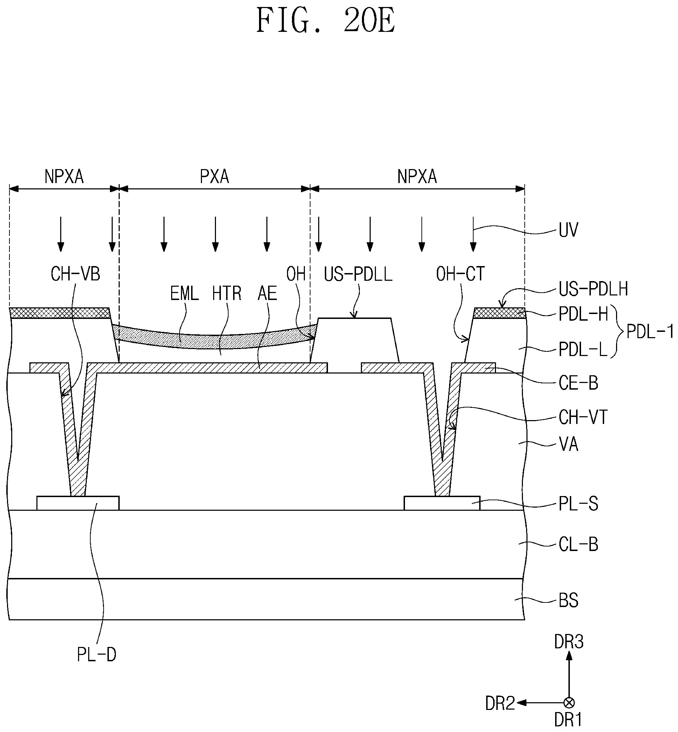

FIG. 20E is a diagram illustrating example steps of performing a surface treatment on the upper surface of a pixel-defining layer. Referring to FIG. 20E, ultraviolet (UV) light may be emitted from above the pixel-defining layer PDL-1. Due to the ultraviolet (UV) light, the upper surface US-PDLL of the first pixel-defining portion PDL-L loses the liquid repellency, and the upper surface US-PDLH of the second pixel-defining portion PDL-H partially decreases in liquid repellency but still retains the liquid repellency.

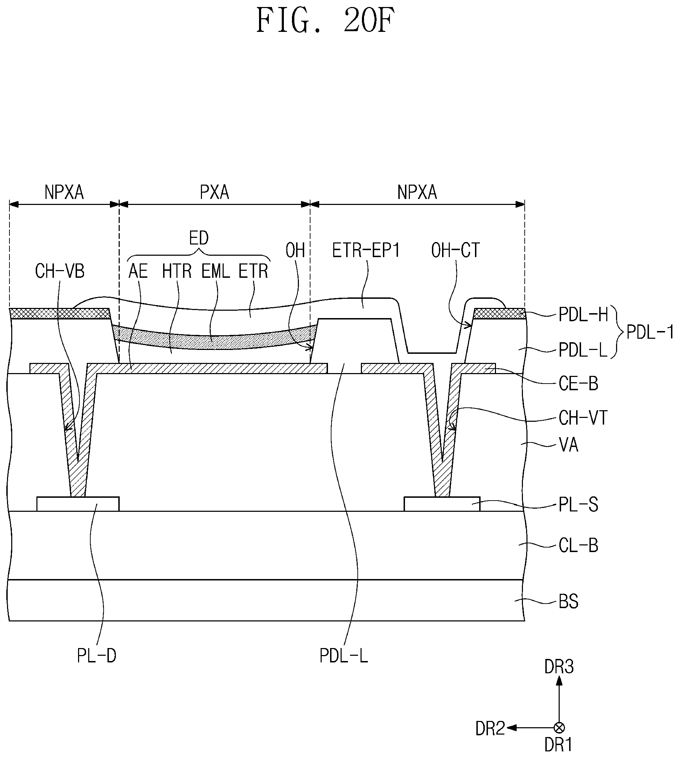

FIG. 20F illustrates example steps of forming the electron transport region ETR. The electron transport region ETR may be provided on the light-emitting layer EML, and the electron transport region ETR may extend from the pixel opening OH and be arranged along the contact opening OH-CT. The contact region ETR-EP1 of the electron transport region ETR extending toward the contact opening OH-CT may be arranged along the shape of the contact opening OH-CT, and may extend onto the pixel-defining layer PDL that defines the contact opening OH-CT and has a stack structure of the first pixel-defining portion PDL-L and the second pixel-defining portion PDL-H. The electron transport region ETR may completely overlap the pixel-defining layer that is located between the pixel opening OH and the contact opening OH-CT and includes only the first pixel-defining portion PDL-L. The electron transport region ETR may extend into the contact opening OH-CT and come into contact with the lower contact electrode CE-B over a sufficient area.

The electronic device according to an embodiment includes the display module according to an embodiment described above. The electronic device according to an embodiment may be configured such that the light-emitting element does not include a second electrode that is a common electrode, but includes a structure in which the electron transport region is electrically connected to the voltage line, thereby exhibiting excellent electrical characteristics and improved display quality. The electronic device according to an embodiment includes a display module according to an embodiment and a power module for supplying electrical signals to the display module.

The display module according to an embodiment of the present disclosure may include the voltage line extending into the display region, and the voltage line may be electrically connected to the electron transport region of the light-emitting element via the lower contact electrode disposed in the opening defined in the insulating layer. Accordingly, the voltage drop of the light-emitting element across the display region may be reduced, thereby exhibiting excellent electrical characteristics and improved display quality. In addition, in the light-emitting element in the display module according to an embodiment, an additional electrode facing the pixel electrode is omitted, thereby achieving the effect of improving economic efficiency of the process. Furthermore, the additional electrode in the light-emitting element according to the related art, which is provided entirely as a common electrode, is omitted, thereby achieving the effect of reducing the voltage drop due to the surface resistance of the common electrode.

The electronic device according to an embodiment may include the display module according to an embodiment described above that displays an image, and may exhibit excellent display quality, superior electrical characteristics and reliability.

In the display module according to the embodiment, the light-emitting element and the voltage line are electrically connected to each other in the contact opening region adjacent to the light-emitting element, thereby improving the characteristics of voltage drop depending on the distance between the voltage line and the light-emitting element.

The electronic device according to embodiment may have a structure in which the voltage line for providing voltage is connected to the light-emitting element via the contact opening region adjacent to the light-emitting element, thereby exhibiting excellent electrical characteristics and reliability characteristics.

Although the present display module has been described with reference to the embodiments shown in the drawings, these are merely examples, and those skilled in the art will understand that various modifications and equivalent other embodiments are possible therefrom. Therefore, the disclosed subject matter should not be limited to any single embodiment described herein.

## Claims

1. A display module (DM), comprising:
a circuit layer (DP-CL) comprising a voltage line (PL-S), an insulating layer (VA) disposed on the voltage line (PL-S), the insulating layer (VA) having an opening (CH-VT) defined therein, and a lower contact electrode (CE-B) located in the opening (CH-VT) defined in the insulating layer (VA), the lower contact electrode (CE-B) being connected to the voltage line (PL-S); and
a display layer (DP-EL) disposed on the circuit layer (DP-CL) and comprising a pixel-defining layer (PDL, PDL-1) and a light-emitting element (ED), the pixel-defining layer (PDL, PDL-1) defining a contact opening (OH-CT) and a pixel opening (OH), the contact opening (OH-CT) exposing at least a portion of the lower contact electrode (CE-B), and the pixel opening (OH) not overlapping the contact opening (OH-CT), the light-emitting element (ED) being disposed in the pixel opening (OH),
wherein the light-emitting element (ED) comprises a pixel electrode (AE) exposed at the pixel opening (OH), a hole transport region (HTR) disposed on the pixel electrode (AE), a light-emitting layer (EML) disposed on the hole transport region (HTR), and an electron transport region (ETR) disposed on the light-emitting layer (EML), and
wherein the electron transport region (ETR) is electrically connected to the lower contact electrode (CE-B) via the contact opening (OH-CT).

2. The display module (DM) of claim 1, wherein the display layer (DP-EL) further comprises:
an upper contact electrode (CE-T) located in the contact opening (OH-CT),
a lower surface of the upper contact electrode (CE-T) being in contact with the lower contact electrode (CE-B), and
an edge of the upper contact electrode (CE-T) being disposed on the pixel-defining layer (PDL).

3. The display module (DM) of claim 2, wherein the electron transport region (ETR) is in contact with the edge of the upper contact electrode (CE-T), the edge being on one side of the upper contact electrode (CE-T).

4. The display module (DM) of claim 3, wherein an edge (PNP-HT) of the hole transport region (HTR) is located on a side surface of the pixel-defining layer (PDL), and an edge (PNP-EM) of the light-emitting layer (EML) is located on the side surface of the pixel-defining layer (PDL), and
an edge (PNP-HT) of the electron transport region (ETR) is disposed on an upper surface of the pixel-defining layer (PDL).

5. The display module (DM) of claim 2, wherein the electron transport region (ETR) overlaps at least a portion of the upper contact electrode (CE-T).

6. The display module (DM) of claim 5, wherein an edge (PNP-ET) of the hole transport region (HTR) is located on a side surface of the pixel-defining layer (PDL), and an edge (PNP-EM) of the light-emitting layer (EML) is located on the side surface of the pixel-defining layer (PDL), and
an edge (PNP-ET) of the electron transport region (ETR) is disposed on an upper surface of the upper contact electrode (CE-T).

7. The display module (DM) of any one of claims 1 to 6, wherein an upper surface of the pixel-defining layer (PDL, PDL-1) has a higher liquid repellency than a side surface of the pixel-defining layer (PDL, PDL-1), and
a surface energy of the electron transport region (ETR) is greater than a surface energy of the hole transport region (HTR), and the surface energy of the electron transport region (ETR) is greater than a surface energy of the light-emitting layer (EML).

8. The display module (DM) of claim 1, wherein the electron transport region (ETR) extends into the contact opening (OH-CT) and comes into direct contact with the lower contact electrode (CE-B).

9. The display module (DM) of claim 8,
wherein the pixel-defining layer (PDL-1) comprises a first pixel-defining portion (PDL-L) disposed directly on the insulating layer (VA), and a second pixel-defining portion (PDL-H) disposed on the first pixel-defining portion (PDL-L), the second pixel-defining portion (PDL-H) having an upper surface (US-PDLH) having a liquid repellency, and
wherein an entirety of the pixel-defining layer (PDL-1) located between the pixel opening (OH) and the contact opening (OH-CT) and completely overlapping the electron transport region (ETR) is within the first pixel-defining portion (PDL-L).

10. The display module (DM) of any one of claims 1 to 9, wherein the light-emitting layer (EML) comprises a quantum dot.

11. The display module (DM) of any one of claims 1 to 10, wherein the light-emitting element (ED) does not comprise an additional electrode facing the pixel electrode (AE) with the light-emitting layer (EML) therebetween.

12. An electronic device (EA) comprising:
a display module (DM) configured to provide an image; and
a power module (PM) configured to supply power to the display module (DM),
wherein the display module (DM) is any one of claims 1 to 11.

13. The electronic device (EA) of claim 12, further comprising at least one of a processor (PR) or a memory (MR),
wherein the electronic device (EA) represents an image display device, a wearable device, or an in-vehicle device.
